# EUROPEAN PATENT APPLICATION

(11) **EP 4 845 333 A1**
(43) Date of publication of application: **25.11.2026**
(21) Application number: 26180051.0
(22) Date of filing: 20.05.2026
(51) Int. Cl.: H10B 63/00, H10B 63/10, H10N 70/00

(54) **CELL INTEGRATION FOR A VERTICAL MEMORY DEVICE**

(30) Priority: 22.05.2025 US 202563810149 P; 05.05.2026 US 202619668390
(71) Applicant: Micron Technology, Inc., Boise, ID 83716-9632 (US)
(72) Inventor: VARESI, Enrico, Boise, 83716-9632 (US); TORTORELLI, Innocenzo, Boise, 83716-9632 (US); BERTUCCIO, Massimo Ernesto, Boise, 83716-9632 (US); VORA, Nirav, Boise, 83716-9632 (US)
(74) Representative: Marks & Clerk LLP

(57) **Abstract**

Methods, systems, and devices for cell integration for a vertical memory device are described. Piers may act as a separator between memory cells or other features of a memory die. For example, piers may extend into at least a portion of an interleaved comb structure for memory cell formation and may act as barriers when depositing materials in the interleaved comb structure. Memory cells formed within the comb structure may be formed using a relatively thin deposition of storage material at boundary surface of cavities in alternating piers of the pier structure. The storage material may be subsequently sealed by adding a sealing material that is in contact with exposed surfaces of the storage material. After sealing the storage material a first time, the storage material and the sealing material may be recessed to decrease a size of the storage material before sealing the exposed surfaces of the storage material a second time.

## Description

### CROSS REFERENCE

The present Application for Patent claims priority to U.S. Patent Application No. 19/668,390 by Varesi et al., entitled "CELL INTEGRATION FOR A VERTICAL MEMORY DEVICE," filed May 05, 2026, and claims priority to U.S. Patent Application No. 63/810,149 by Varesi et al., entitled "CELL INTEGRATION FOR A VERTICAL MEMORY DEVICE," filed May 22, 2025, each of which is assigned to the assignee hereof.

### TECHNICAL FIELD

The following relates to one or more systems for memory, including cell integration for a vertical memory device.

### BACKGROUND

Memory devices are widely used to store information in devices such as computers, user devices, wireless communication devices, cameras, digital displays, and others. Information is stored by programming memory cells within a memory device to various states. For example, binary memory cells may be programmed to one of two supported states, often denoted by a logic 1 or a logic 0. In some examples, a single memory cell may support more than two states, any one of which may be stored. To access the stored information, the memory device may read (e.g., sense, detect, retrieve, determine) states from the memory cells. To store information, the memory device may write (e.g., program, set, assign) states to the memory cells.

Various types of memory devices exist, including magnetic hard disks, random access memory (RAM), read-only memory (ROM), dynamic RAM (DRAM), synchronous dynamic RAM (SDRAM), static RAM (SRAM), ferroelectric RAM (FeRAM), magnetic RAM (MRAM), resistive RAM (RRAM), flash memory, phase change memory (PCM), self-selecting memory, chalcogenide memory technologies, not-or (NOR) and not-and (NAND) memory devices, and others. Memory cells may be described in terms of volatile configurations or non-volatile configurations. Memory cells configured in a non-volatile configuration may maintain stored logic states for extended periods of time even in the absence of an external power source. Memory cells configured in a volatile configuration may lose stored states when disconnected from an external power source.

### BRIEF DESCRIPTION OF THE DRAWINGS

FIG. 1 shows an example of a memory array that supports cell integration for a vertical memory device in accordance with examples as disclosed herein.
FIG. 2 shows a top view of an example of a memory array that supports cell integration for a vertical memory device in accordance with examples as disclosed herein.
FIGs. 3A and 3B show side views of an example of a memory array that supports cell integration for a vertical memory device in accordance with examples as disclosed herein.
FIGs. 4A-22B illustrate examples of aspects of a manufacturing process of a memory array that supports cell integration for a vertical memory device in accordance with examples as disclosed herein.
FIGs. 23A and 23B show a flowchart illustrating a method or methods that support cell integration for a vertical memory device in accordance with examples as disclosed herein.

### DETAILED DESCRIPTION

In some semiconductor manufacturing operations, voids may be formed between layers of material deposited over a substrate, and other materials may be deposited in the voids (e.g., between the layers of material) to form various structures (e.g., circuit structures). For example, in some memory applications, voids may be formed between layers of a dielectric material, and features of a memory array, such as access lines or memory cells (e.g., of different levels of the memory array), may be formed from materials deposited between the layers of the dielectric material.

In some examples, a semiconductor device (e.g., a memory die) may include pier structures formed in contact with features formed from alternating layers of materials deposited over a substrate, which may provide mechanical support for subsequent processing steps. For example, a memory die may include alternating layers of a first material and a second material, which may be formed into various cross-sectional patterns. In some examples, the alternating layers may be formed into a pair of interleaved comb structures. Pier structures may be formed in contact with the cross sectional patterns such that, when either the first material or the second material is removed (e.g., in a selective etching operation) to form voids (e.g., along a direction relative to the substrate), the pier structures provide mechanical support for the remaining material. By implementing such pier structures, the voids may be formed with improved stability or tolerances, such that formation of features within the voids (e.g., circuit structures, access lines, memory cells) may be performed with reduced variability or otherwise improved consistency.

In some examples, the piers may further act as a separator between memory cells or other features of the memory die. For example, the piers may extend into at least a portion of the interleaved comb structures, and may accordingly act as barriers during subsequent depositions of materials. However, memory cells formed within some pier structures may lack confinement (e.g., cell confinement) and thus may be relatively large, and techniques which seek to reduce the cell size may be ineffective or may result in cell-to-cell variability in size and/or composition.

In accordance with examples described herein, memory cells may be formed using a relatively thin deposition of storage material at boundary walls (e.g., surfaces) of cavities in alternating piers of a pier structure. The storage material may be subsequently sealed by adding a sealing material (e.g., dielectric material) that is in contact with exposed surfaces of the storage material. In some examples, after sealing the storage material a first time, the storage material and the sealing material may be recessed to further decrease the size of the memory cells before sealing the exposed surfaces of the storage material a second time. By forming memory cells using the described techniques, memory cells may be formed within the pier structure that have a relatively smaller cell size and are more confined. Confinement of memory cells, which may be elsewhere referred to herein as cell confinement, may refer to a containment of the storage material, and the resulting memory cells formed thereof, within a memory array of the semiconductor device. By reducing cell size and increasing cell confinement, the examples disclosed herein may support increased read windows when accessing the memory cells, which may increase access speeds, reduce latency, and increase accuracy of memory storage.

In addition to applicability in memory systems as described herein, techniques for cell integration for a vertical memory device may be generally implemented to improve the performance of various electronic devices and systems (including artificial intelligence (AI) applications, augmented reality (AR) applications, virtual reality (VR) applications, and gaming). Some electronic device applications, including high-performance applications such as AI, AR, VR, and gaming, may be associated with relatively high processing requirements to satisfy user expectations. As such, increasing processing capabilities of the electronic devices by decreasing response times, improving power consumption, reducing complexity, increasing data throughput or access speeds, decreasing communication times, or increasing memory capacity or density, among other performance indicators, may improve user experience or appeal. Implementing the techniques described herein may improve the performance of electronic devices by decreasing cell size and increasing cell containment, which may result in higher read windows, faster access speeds, and increased accuracy of data storage and access, among other benefits.

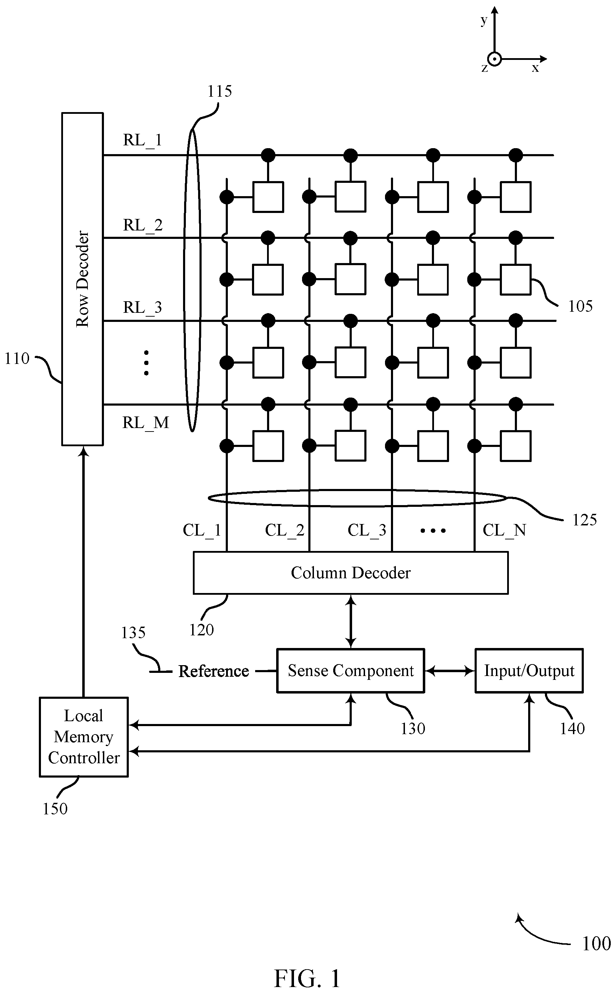

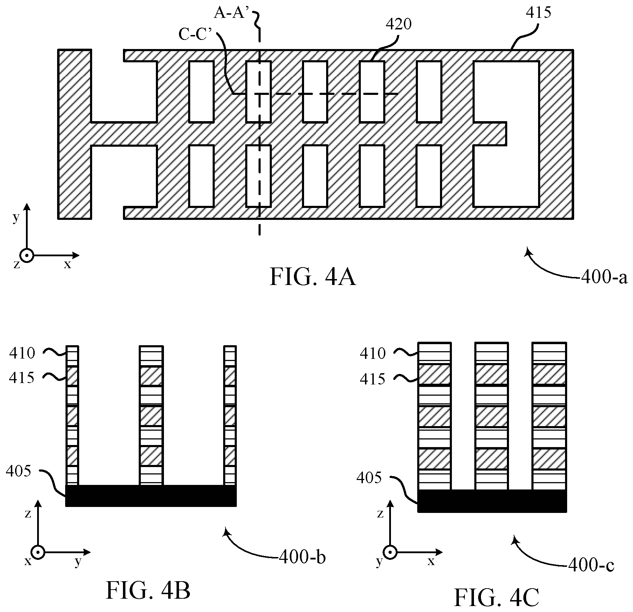

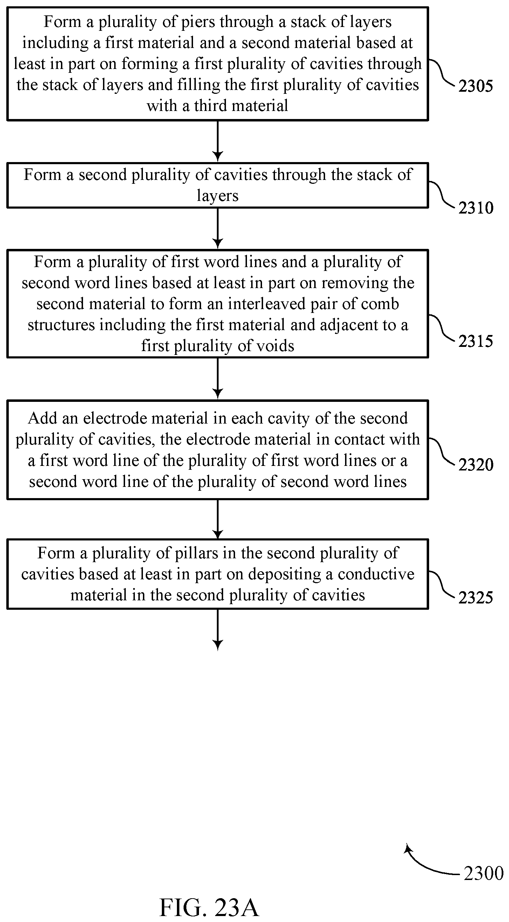

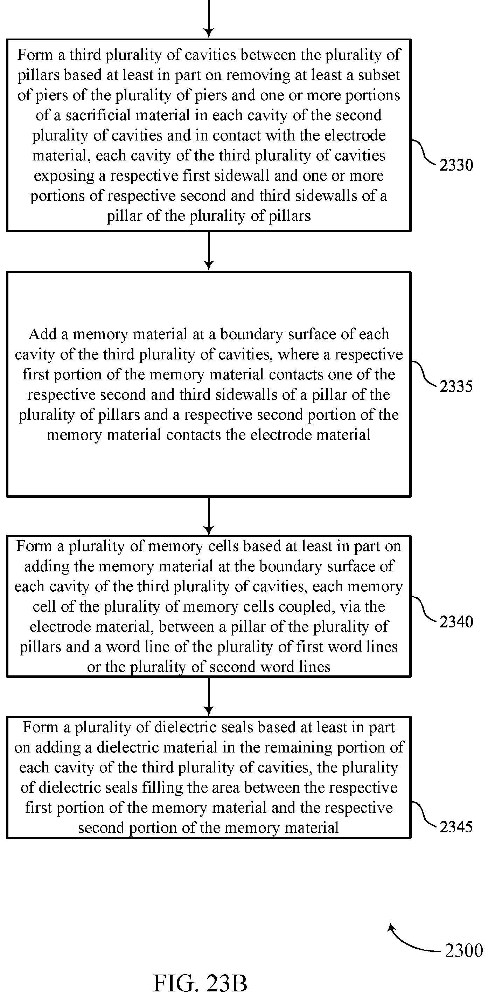

Features of the disclosure are initially described in the context of memory devices and arrays with reference to FIGs. 1, 2, 3A, and 3B. Features of the disclosure are described in the context of steps of a manufacturing process of a memory array with reference to FIGs. 4A-22B. These and other features of the disclosure are further illustrated by and described with reference to an apparatus diagram and flowcharts that relate to cell integration for a vertical memory device as described with reference to FIGs. 23-24.

**FIG. 1** shows an example of a memory device 100 that supports cell integration for a vertical memory device in accordance with examples as disclosed herein. In some examples, the memory device 100 may be referred to as or include a memory die, a memory chip, or an electronic memory apparatus. The memory device 100 may be operable to provide locations to store information (e.g., physical memory addresses) that may be used by a system (e.g., a host device coupled with the memory device 100, for writing information, for reading information).

The memory device 100 may include one or more memory cells 105 that each may be programmable to store different logic states (e.g., a programmed one of a set of two or more possible states). For example, a memory cell 105 may be operable to store one bit of information at a time (e.g., a logic 0 or a logic 1). In some examples, a memory cell 105 (e.g., a multi-level memory cell 105) may be operable to store more than one bit of information at a time (e.g., a logic 00, logic 01, logic 10, a logic 11). In some examples, the memory cells 105 may be arranged in an array.

A memory cell 105 may store a logic state using a configurable material, which may be referred to as a memory element, a storage element, a memory storage element, a material element, a material memory element, a material portion, or a polarity-written material portion, among others. A configurable material of a memory cell 105 may refer to a chalcogenide-based storage component. For example, a chalcogenide storage element may be used in a phase change memory cell, a thresholding memory cell, or a self-selecting memory cell, among other architectures.

In some examples, the material of a memory cell 105 may include a chalcogenide material or other alloy including selenium (Se), tellurium (Te), arsenic (As), antimony (Sb), carbon (C), germanium (Ge), silicon (Si), or indium (In), or various combinations thereof. In some examples, a chalcogenide material having primarily selenium (Se), arsenic (As), and germanium (Ge) may be referred to as a SAG-alloy. In some examples, a SAG-alloy may also include silicon (Si) and such chalcogenide material may be referred to as SiSAG-alloy. In some examples, SAG-alloy may include silicon (Si) or indium (In) or a combination thereof and such chalcogenide materials may be referred to as SiSAG-alloy or InSAG-alloy, respectively, or a combination thereof. In some examples, the chalcogenide material may include additional elements such as hydrogen (H), oxygen (O), nitrogen (N), chlorine (Cl), or fluorine (F), each in atomic or molecular forms.

In some examples, a memory cell 105 may be an example of a phase change memory cell. In such examples, the material used in the memory cell 105 may be based on an alloy (such as the alloys listed above) and may be operated so as to change to different physical state (e.g., undergo a phase change) during normal operation of the memory cell 105. For example, a phase change memory cell 105 may be associated with a relatively disordered atomic configuration (e.g., a relatively amorphous state) and a relatively ordered atomic configuration (e.g., a relatively crystalline state). A relatively disordered atomic configuration may correspond to a first logic state (e.g., a RESET state, a logic 0) and a relatively ordered atomic configuration may correspond to a second logic state (e.g., a logic state different than the first logic state, a SET state, a logic 1).

In some examples (e.g., for thresholding memory cells 105, for self-selecting memory cells 105), some or all of the set of logic states supported by the memory cells 105 may be associated with a relatively disordered atomic configuration of a chalcogenide material (e.g., the material in an amorphous state may be operable to store different logic states). In some examples, the storage element of a memory cell 105 may be an example of a self-selecting storage element. In such examples, the material used in the memory cell 105 may be based on an alloy (e.g., the alloys listed above) and may be operated so as to undergo a change to a different physical state during normal operation of the memory cell 105. For example, a self-selecting or thresholding memory cell 105 may have a high threshold voltage state and a low threshold voltage state, where a corresponding "threshold voltage" may refer to a voltage at which or above which the memory cell 105 transitions from a relatively higher-resistance (e.g., non-conductive) state to a relatively lower-resistance (e.g., conductive) state, such as in response to an applied voltage. A high threshold voltage state may correspond to a first logic state (e.g., a RESET state, a logic 0) and a low threshold voltage state may correspond to a second logic state (e.g., a logic state different than the first logic state, a SET state, a logic 1).

During a write operation (e.g., a programming operation) of a self-selecting or thresholding memory cell 105, a polarity used for a write operation may influence (e.g., determine, set, program) a behavior or characteristic of the material of the memory cell 105, such as a thresholding characteristic (e.g., a threshold voltage) of the material. A difference between thresholding characteristics (e.g., resistivity characteristics, conductivity characteristics) of the material of the memory cell 105 for different logic states stored by the material of the memory cell 105 (e.g., a difference between threshold voltages when the material is storing a logic state '0' versus a logic state '1') may correspond to the read window of the memory cell 105.

The memory device 100 may include access lines (e.g., row lines 115 each extending along an illustrative x-direction, column lines 125 each extending along an illustrative y-direction) arranged in a pattern, such as a grid-like pattern. Access lines may be formed with one or more conductive materials. In some examples, row lines 115, or some portion thereof, may be referred to as word lines. In some examples, column lines 125, or some portion thereof, may be referred to as digit lines or bit lines. References to access lines, or their analogues, are interchangeable without loss of understanding. Memory cells 105 may be positioned at intersections of access lines, such as row lines 115 and the column lines 125. In some examples, memory cells 105 may also be arranged (e.g., addressed) along an illustrative z-direction, such as in an implementation of sets of memory cells 105 being located at different levels (e.g., layers, decks, planes, tiers) along the illustrative z-direction. In some examples, a memory device 100 that includes memory cells 105 at different levels may be supported by a different configuration of access lines, decoders, and other supporting circuitry than shown.

Operations such as read operations and write operations may be performed on the memory cells 105 by activating access lines such as one or more of a row line 115 or a column line 125, among other access lines associated with alternative configurations. For example, by activating a row line 115 and a column line 125 (e.g., applying a voltage to the row line 115 or the column line 125), a memory cell 105 may be accessed in accordance with their intersection. An intersection of a row line 115 and a column line 125, among other access lines, in various two-dimensional or three-dimensional configuration may be referred to as an address of a memory cell 105. In some examples, an access line may be a conductive line coupled with a memory cell 105 and may be used to perform access operations on the memory cell 105. In some examples, the memory device 100 may perform operations responsive to commands, which may be issued by a host device coupled with the memory device 100 or may be generated by the memory device 100 (e.g., by a local memory controller 150).

Accessing the memory cells 105 may be controlled through one or more decoders, such as a row decoder 110 or a column decoder 120, among other examples. For example, a row decoder 110 may receive a row address from the local memory controller 150 and activate a row line 115 based on the received row address. A column decoder 120 may receive a column address from the local memory controller 150 and may activate a column line 125 based on the received column address.

The sense component 130 may be operable to detect a state (e.g., a material state, a resistance state, a threshold state) of a memory cell 105 and determine a logic state of the memory cell 105 based on the detected state. The sense component 130 may include one or more sense amplifiers to convert (e.g., amplify) a signal resulting from accessing the memory cell 105 (e.g., a signal of a column line 125 or other access line). The sense component 130 may compare a signal detected from the memory cell 105 to a reference 135 (e.g., a reference voltage, a reference charge, a reference current). The detected logic state of the memory cell 105 may be provided as an output of the sense component 130 (e.g., to an input/output component 140), and may indicate the detected logic state to another component of the memory device 100 or to a host device coupled with the memory device 100.

The local memory controller 150 may control the accessing of memory cells 105 through the various components (e.g., a row decoder 110, a column decoder 120, a sense component 130, among other components). In some examples, one or more of a row decoder 110, a column decoder 120, and a sense component 130 may be co-located with the local memory controller 150. The local memory controller 150 may be operable to receive information (e.g., commands, data) from one or more different controllers (e.g., an external memory controller associated with a host device, another controller associated with the memory device 100), translate the information into a signaling that can be used by the memory device 100, perform one or more operations on the memory cells 105 and communicate data from the memory device 100 to a host device based on performing the one or more operations. The local memory controller 150 may generate row address signals and column address signals to activate access lines such as a target row line 115 and a target column line 125. The local memory controller 150 also may generate and control various signals (e.g., voltages, currents) used during the operation of the memory device 100. In general, the amplitude, the shape, or the duration of an applied signal discussed herein may be varied and may be different for the various operations discussed in operating the memory device 100.

The local memory controller 150 may be operable to perform one or more access operations on one or more memory cells 105 of the memory device 100. Examples of access operations may include a write operation, a read operation, a refresh operation, a precharge operation, or an activate operation, among others. In some examples, access operations may be performed by or otherwise coordinated by the local memory controller 150 in response to access commands (e.g., from a host device). The local memory controller 150 may be operable to perform other access operations not listed here or other operations related to the operating of the memory device 100 that are not directly related to accessing the memory cells 105.

Piers may act as a separator between memory cells 105 or other features of a memory device 100. For example, piers may extend into at least a portion of an interleaved comb structure for formation of the memory cells 105 and may act as barriers when depositing materials in the interleaved comb structure. Memory cells 105 formed within the comb structure may be formed using a relatively thin deposition of storage material at boundary surface of cavities in alternating piers of the pier structure. The storage material may be subsequently sealed by adding a sealing material that is in contact with exposed surfaces of the storage material. After sealing the storage material a first time, the storage material and the sealing material may be recessed to decrease a size of the storage material before sealing the exposed surfaces of the storage material a second time.

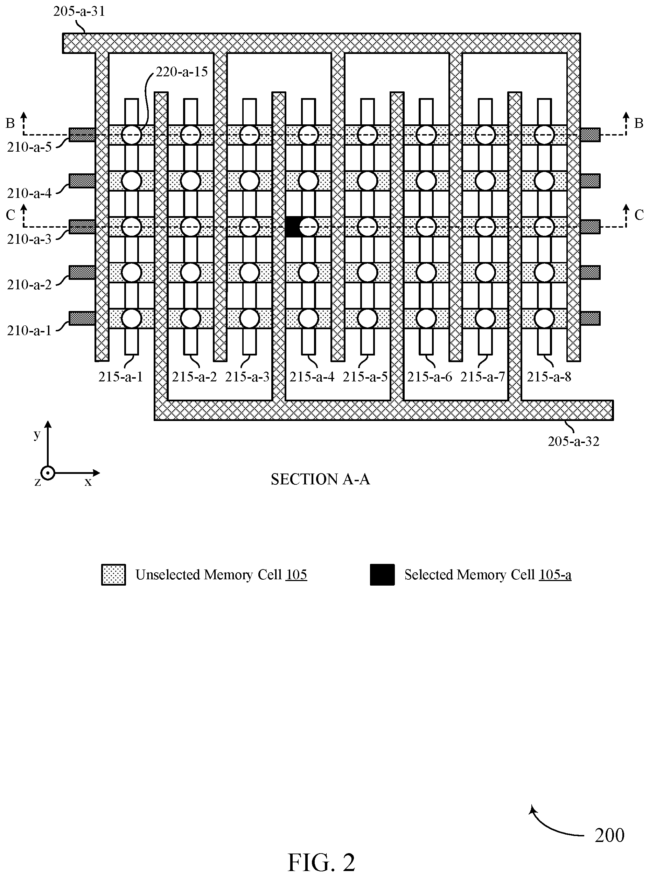

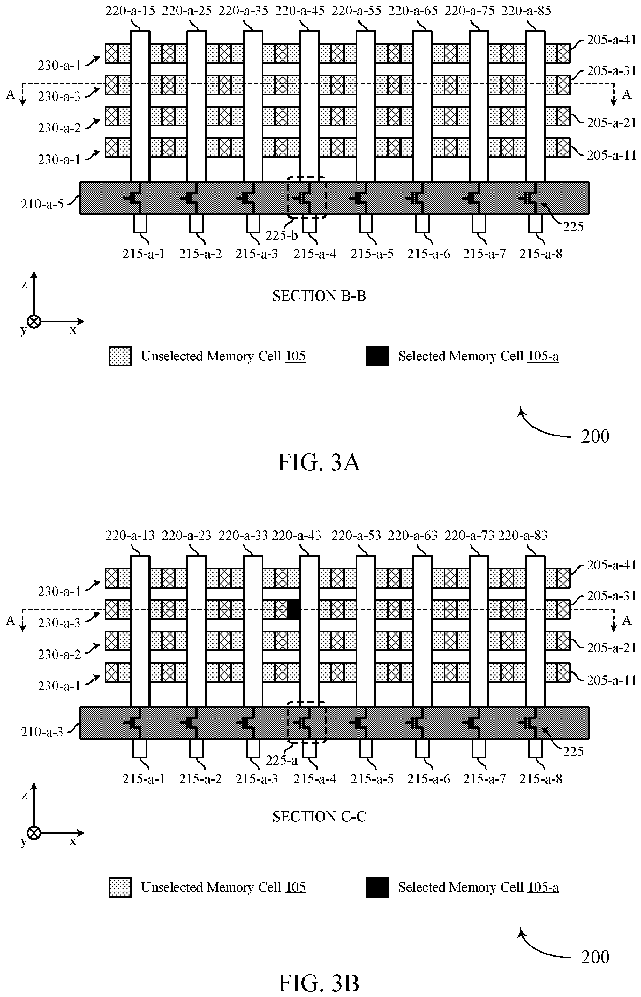

**FIGs. 2****,** **3A, and 3B** show an example of a memory array 200 that supports cell integration for a vertical memory device in accordance with examples as disclosed herein. The memory array 200 may be included in a memory device 100, and illustrates an example of a three-dimensional arrangement of memory cells 105 that may be accessed by various conductive structures (e.g., access lines). FIG. 2 illustrates a top section view (e.g., SECTION A-A) of the memory array 200 relative to a cut plane A-A as shown in FIGs. 3A and 3B. FIG. 3A illustrates a side section view (e.g., SECTION B-B) of the memory array 200 relative to a cut plane B-B as shown in FIG. 2. FIG. 3B illustrates a side section view (e.g., SECTION C-C) of the memory array 200 relative to a cut plane C-C as shown in FIG. 2. The section views may be examples of cross-sectional views of the memory array 200 with some aspects (e.g., dielectric structures) removed for clarity. Elements of the memory array 200 may be described relative to an x-direction, a y-direction, and a z-direction, as illustrated in each of FIGs. 2, 3A, and 3B. Although some elements included in FIGs. 2, 3A, and 3B are labeled with a numeric indicator, other corresponding elements are not labeled, although they are the same or would be understood to be similar, in an effort to increase visibility and clarity of the depicted features. Further, although some quantities of repeated elements are shown in the illustrative example of memory array 200, techniques in accordance with examples as described herein may be applicable to any quantity of such elements, or ratios of quantities between one repeated element and another.

In the example of memory array 200, memory cells 105 and word lines 205 may be distributed along the z-direction according to levels 230 (e.g., decks, layers, planes, tiers, as illustrated in FIGs. 3A and 3B). In some examples, the z-direction may be orthogonal to a substrate (not shown) of the memory array 200, which may be below the illustrated structures along the z-direction. Although the illustrative example of memory array 200 includes four levels 230, a memory array 200 in accordance with examples as disclosed herein may include any quantity of one or more levels 230 (e.g., 64 levels, 128 levels) along the z-direction.

Each word line 205 may be an example of a portion of an access line that is formed by one or more conductive materials (e.g., one or more metal portions, one or more metal alloy portions). As illustrated, a word line 205 may be formed in a comb structure, including portions (e.g., projections, tines) extending along the y-direction through gaps (e.g., alternating gaps) between pillars 220. For example, as illustrated, the memory array 200, may include two word lines 205 per level 230 (e.g., according to odd word lines 205-a-*n*1 and even word lines 205-a-*n*2 for a given level, n), where such word lines 205 of the same level 230 may be described as being interleaved (e.g., with portions of an odd word line 205-a-*n*1 projecting along the y-direction between portions of an even word line 205-a-*n*2, and vice versa). In some examples, an odd word line 205 (e.g., of a level 230) may be associated with a first memory cell 105 on a first side (e.g., along the x-direction) of a given pillar 220 and an even word line (e.g., of the same level 230) may be associated with a second memory cell 105 on a second side (e.g., along the x-direction, opposite the first memory cell 105) of the given pillar 220. Thus, in some examples, memory cells 105 of a given level 230 may be addressed (e.g., selected, activated) in accordance with an even word line 205 or an odd word line 205.

Each pillar 220 may be an example of a portion of an access line (e.g., a conductive pillar portion) that is formed by one or more conductive materials (e.g., one or more metal portions, one or more metal alloy portions). As illustrated, the pillars 220 may be arranged in a two-dimensional array (e.g., in an xy-plane) having a first quantity of pillars 220 along a first direction (e.g., eight pillars along the x-direction, eight rows of pillars), and having a second quantity of pillars 220 along a second direction (e.g., five pillars along the y-direction, five columns of pillars). Although the illustrative example of memory array 200 includes a two-dimensional arrangement of eight pillars 220 along the x-direction and five pillars 220 along the y-direction, a memory array 200 in accordance with examples as disclosed herein may include any quantity of pillars 220 along the x-direction and any quantity of pillars 220 along the y-direction. Further, as illustrated, each pillar 220 may be coupled with a respective set of memory cells 105 (e.g., along the z-direction, one or more memory cells 105 for each level 230). A pillar 220 may have a cross-sectional area in an xy-plane that extends along the z-direction. Although illustrated with a circular cross-sectional area in the xy-plane, a pillar 220 may be formed with a different shape, such as having an elliptical, square, rectangular, polygonal, or other cross-sectional area in an xy-plane.

The memory cells 105 each may include a chalcogenide material. In some examples, the memory cells 105 may be examples of thresholding memory cells. Each memory cell 105 may be accessed (e.g., addressed, selected) according to an intersection between a word line 205 (e.g., a level selection, which may include an even or odd selection within a level 230) and a pillar 220. For example, as illustrated, a selected memory cell 105-a of the level 230-a-3 may be accessed according to an intersection between the pillar 220-a-43 and the word line 205-a-32.

A memory cell 105 may be accessed (e.g., written to, read from) by applying an access bias (e.g., an access voltage, V_{access}, which may be a positive voltage or a negative voltage) across the memory cell 105. In some examples, an access bias may be applied by biasing a selected word line 205 with a first voltage (e.g., V_{access}/2) and by biasing a selected pillar 220 with a second voltage (e.g., -V_{access}/2), which may have an opposite sign relative to the first voltage. Regarding the selected memory cell 105-a, a corresponding access bias (e.g., the first voltage) may be applied to the word line 205-a-32, while other unselected word lines 205 may be grounded (e.g., biased to 0V). In some examples, a word line bias may be provided by a word line driver (not shown) coupled with one or more of the word lines 205.

To apply a corresponding access bias (e.g., the second voltage) to a pillar 220, the pillars 220 may be configured to be selectively coupled with a sense line 215 (e.g., a digit line, a column line, an access line extending along the y-direction) via a respective transistor 225 coupled between (e.g., physically, electrically) the pillar 220 and the sense line 215. In some examples, the transistors 225 may be vertical transistors (e.g., transistors having a channel along the z-direction, transistors having a semiconductor junction along the z-direction), which may be formed above the substrate of the memory array 200 using various techniques (e.g., thin film techniques). In some examples, a selected pillar 220, a selected sense line 215, or a combination thereof may be an example of a selected column line 125 described with reference to FIG. 1 (e.g., a bit line).

The transistors 225 (e.g., a channel portion of the transistors 225) may be activated by gate lines 210 (e.g., activation lines, selection lines, a row line, an access line extending along the x-direction) coupled with respective gates of a set of the transistors 225 (e.g., a set along the x-direction). In other words, each of the pillars 220 may have a first end (e.g., towards the negative z-direction, a bottom end) configured for coupling with an access line (e.g., a sense line 215). In some examples, the gate lines 210, the transistors 225, or both may be considered to be components of a row decoder 110 (e.g., as pillar decoder components). In some examples, the selection of (e.g., biasing of) pillars 220, or sense lines 215, or various combinations thereof, may be supported by a column decoder 120, or a sense component 130, or both.

To apply the corresponding access bias (e.g., -V_{access}/2) to the pillar 220-a-43, the sense line 215-a-4 may be biased with the access bias, and the gate line 210-a-3 may be grounded (e.g., biased to 0V) or otherwise biased with an activation voltage. In an example where the transistors 225 are n-type transistors, the gate line 210-a-3 being biased with a voltage that is relatively higher than the sense line 215-a-4 may activate the transistor 225-a (e.g., cause the transistor 225-a to operate in a conducting state), thereby coupling the pillar 220-a-43 with the sense line 215-a-4 and biasing the pillar 220-a-43 with the associated access bias. However, the transistors 225 may include different channel types, or may be operated in accordance with different biasing schemes, to support various access operations.

In some examples, unselected pillars 220 of the memory array 200 may be electrically floating when the transistor 225-a is activated, or may be coupled with another voltage source (e.g., grounded, via a high-resistance path, via a leakage path) to avoid a voltage drift of the pillars 220. For example, a ground voltage being applied to the gate line 210-a-3 may not activate other transistors coupled with the gate line 210-a-3, because the ground voltage of the gate line 210-a-3 may not be greater than the voltage of the other sense lines 215 (e.g., which may be biased with a ground voltage or may be floating). Further, other unselected gate lines 210, including gate line 210-a-5 as shown in FIG. 3A, may be biased with a voltage equal to or similar to an access bias (e.g., -V_{access}/2, or some other negative bias or bias relatively near the access bias voltage), such that transistors 225 along an unselected gate line 210 are not activated. Thus, the transistor 225-b coupled with the gate line 210-a-5 may be deactivated (e.g., operating in a non-conductive state), thereby isolating the voltage of the sense line 215-a-4 from the pillar 220-a-45, among other pillars 220.

In a write operation, a memory cell 105 may be written to by applying a write bias (e.g., where V_{access} = V_{write}, which may be a positive voltage or a negative voltage) across the memory cell 105. In some examples, a polarity of a write bias may influence (e.g., determine, set, program) a behavior or characteristic of the material of the memory cell 105, such as the threshold voltage of the material. For example, applying a write bias with a first polarity may set the material of the memory cell 105 with a first threshold voltage, which may be associated with storing a logic 0. Further, applying a write bias with a second polarity (e.g., opposite the first polarity) may set the material of the memory cell with a second threshold voltage, which may be associated with storing a logic 1. A difference between threshold voltages of the material of the memory cell 105 for different logic states stored by the material of the memory cell 105 (e.g., a difference between threshold voltages when the material is storing a logic state '0' versus a logic state '1') may correspond to the read window of the memory cell 105.

In a read operation, a memory cell 105 may be read from by applying a read bias (e.g., where V_{access} = V_{read}, which may be a positive voltage or a negative voltage) across the memory cell 105. In some examples, a logic state of the memory cell 105 may be evaluated based on whether the memory cell 105 thresholds (e.g., transitions to a relatively lower-resistance or conductive state, permits current) in the presence of the applied read bias. For example, such a read bias may cause a memory cell 105 storing a first logic state (e.g., a logic 0) to threshold (e.g., permit a current flow, permit a current above a threshold current), and may not cause a memory cell 105 storing a second logic state (e.g., a logic 1) to threshold (e.g., may not permit a current flow, may permit a current below a threshold current).

Piers may act as a separator between memory cells 105 or other features of a memory device 100. For example, piers may extend into at least a portion of an interleaved comb structure for formation of the memory cells 105 and may act as barriers when depositing materials in the interleaved comb structure. Memory cells 105 formed within the comb structure may be formed using a relatively thin deposition of storage material at boundary surface of cavities in alternating piers of the pier structure. The storage material may be subsequently sealed by adding a sealing material that is in contact with exposed surfaces of the storage material. After sealing the storage material a first time, the storage material and the sealing material may be recessed to decrease a size of the storage material before sealing the exposed surfaces of the storage material a second time.

**FIGs. 4A, 4B, and 4C** illustrate examples of aspects of a manufacturing process of a memory array that supports cell integration for a vertical memory device in accordance with examples as disclosed herein.

**FIG. 4A** illustrates a top-down view of aspects of the manufacturing process of a memory array 400-a. In some cases, the memory array 400-a may include an alternating stack of materials formed over a substrate 405. For example, the memory array 400-a may include one or more layers or tiers of a first material 410 and one or more layers or tiers of a second material 415. The manufacturing process may include forming the stack of materials, for example by depositing each layer of the stack of layers. In some examples, the first material 410 may be a dielectric material, such as an oxide material. Additionally, the second material 415 may be an example of another dielectric material, such as a nitride material.

In some cases, the manufacturing process may further include forming a set of cavities 420 through the stack of materials. For example, the set of cavities 420 may be formed by performing a vertical etch through the stack of materials using a first etching mask. In some cases, the etching may terminate above the substrate 405. That is, the substrate 405 may not be etched during the etching process.

**FIG. 4B** illustrates a cross-sectional view aspects of the manufacturing process of a memory array 400-b along section line A-A', while FIG. 4C illustrates a cross-sectional view aspects of the manufacturing process of a memory array 400-c along section line C-C'. FIG. 4A may illustrate the top-down view sectioned through one of the layers of the second material 415.

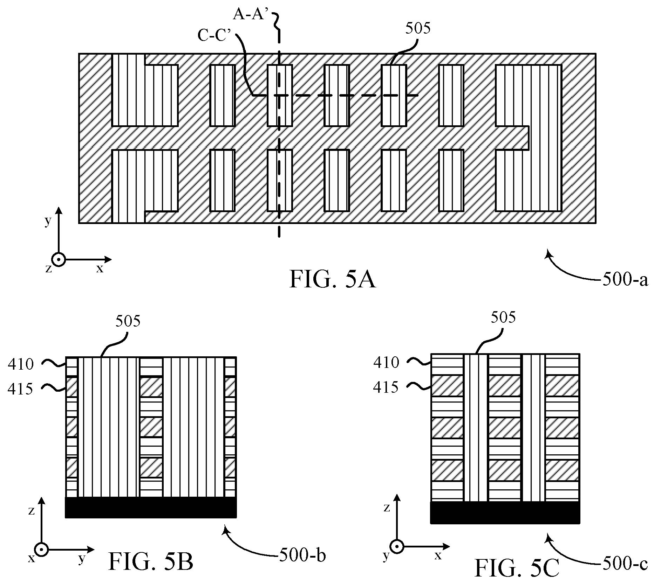

**FIG. 5A, 5B, and 5C** illustrate examples of aspects of the manufacturing process of a memory array that supports cell integration for a vertical memory device in accordance with examples as disclosed herein.

**FIG. 5A** illustrates a top-down view of aspects of the manufacturing process of a memory array 500-a. In some examples, the step of the manufacturing process of the memory array 500-a may include forming a set of piers 505. A pier 505 may be an example of a support structure, such as a pillar or column of dielectric material which adheres to or supports the stack of materials. In some examples, a pier 505 may provide mechanical support to the stack of material during subsequent steps of the manufacturing process. For example, a pier 505 may limit movement of the stack of materials in the x-direction, the y-direction, the z-direction, or any combination thereof.

For example, the manufacturing process may include depositing a pier material, such as a dielectric material, into each of the set of cavities 420. The dielectric material may fill the set of cavities 420, and may contact each of the layers (e.g., each layer of the first material 410 and each layer of the second material 415). Additionally, or alternatively, a pier 505 may include a dielectric liner material, such as an oxide or a nitride (e.g., the first material 410 or the second material 415), and a filler material, such as an aluminum oxide (AlOx), an oxide, or polysilicon. Accordingly, the set of piers 505 may provide mechanical support for the stack of materials during subsequent steps of the manufacturing process. In some examples, the dielectric material of the piers 505 may be the same as the dielectric material of the first material 410. Alternatively, the piers 505 and the first material 410 may be examples of different materials or combinations of materials. For example, the piers 505 may include an oxide liner.

In some examples, forming the set of piers 505 may include a polishing step. For instance, after depositing the pier material, the stack of materials may be polished or planarized, for example using a chemical mechanical polishing (CMP) procedure.

**FIG. 5B** illustrates a cross-sectional view aspects of the manufacturing process of a memory array 500-b along section line A-A', while FIG. **5C** illustrates a cross-sectional view aspects of the manufacturing process of a memory array 500-c along section line C-C'. FIG. 5A may illustrate the top-down view sectioned through one of the layers of the second material 415.

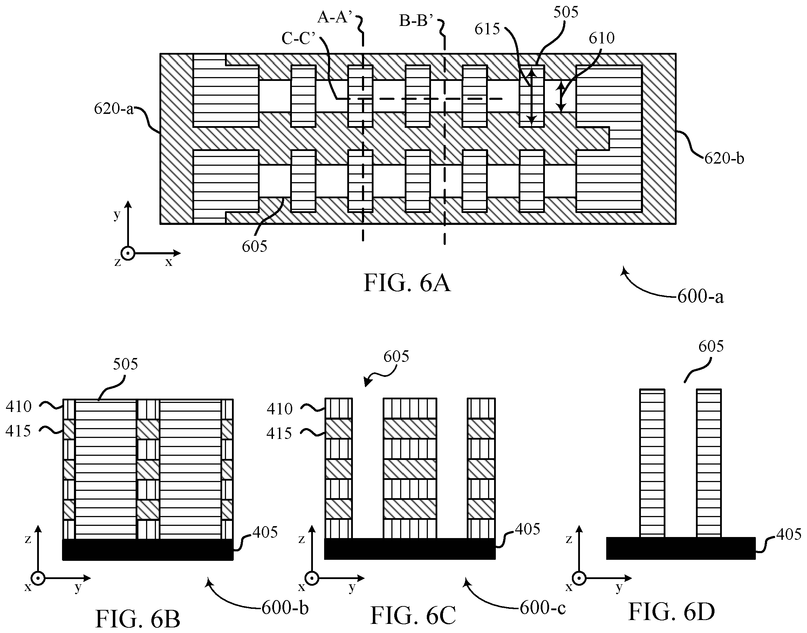

**FIG. 6A, 6B, 6C, and 6D** illustrate examples of aspects of the manufacturing process of a memory array that supports cell integration for a vertical memory device in accordance with examples as disclosed herein.

**FIG. 6A** illustrates a top-down view of aspects of the manufacturing process of a memory array 600-a. In some cases, the memory array 600-a may include a set of cavities 605. The set of cavities 605 may be formed by etching (e.g., via a second vertical etch using a second mask) or removing material from the stack of materials (e.g., the first material 410 and the second material 415). In some cases, forming the set of cavities 605 may expose at least a portion of sidewalls of the piers 505, as well exposing portions of the stack of materials (e.g., as illustrated in FIG. 6C). Additionally, forming the set of cavities 605 may expose portions of the substrate 405. In some examples, the etching process to form the set of cavities 605 may be selective to the material of the set of piers 505. That is, the etching process may selectively remove material, such as the first material 410 and the second material 410, while preserving the material of the set of piers 505 (e.g., the second dielectric material). Accordingly, the pattern used to etch the set of cavities 605 may include a stripe, which may cover at least a portion of the set of piers 505. Alternatively, the pattern used to etch the set of cavities 605 may etching a set of isolated holes (e.g., corresponding to the location of each cavity 605 of the set of cavities 605). In such cases, the etching process may be directional (e.g., etching along the z direction).

In some cases, a length 610 in the y-direction of each cavity 605 of the set of cavities 605 may be less than a length 615 in the y-direction of each pier 505 of the set of piers 505. For example, each pier 505 may extend past respective adjacent cavities 605, which may provide increased mechanical support (e.g., relative to a pier having a same length as a corresponding cavity), for example by more effectively truncating a memory cell formed in a cavity 605 (e.g., around a bit line pillar in the cavity 605). Accordingly, memory cells formed in a cavity 605 and in contact with a pier 505 may be less likely to experience manufacturing defects, which may increase the final density of a manufactured memory array.

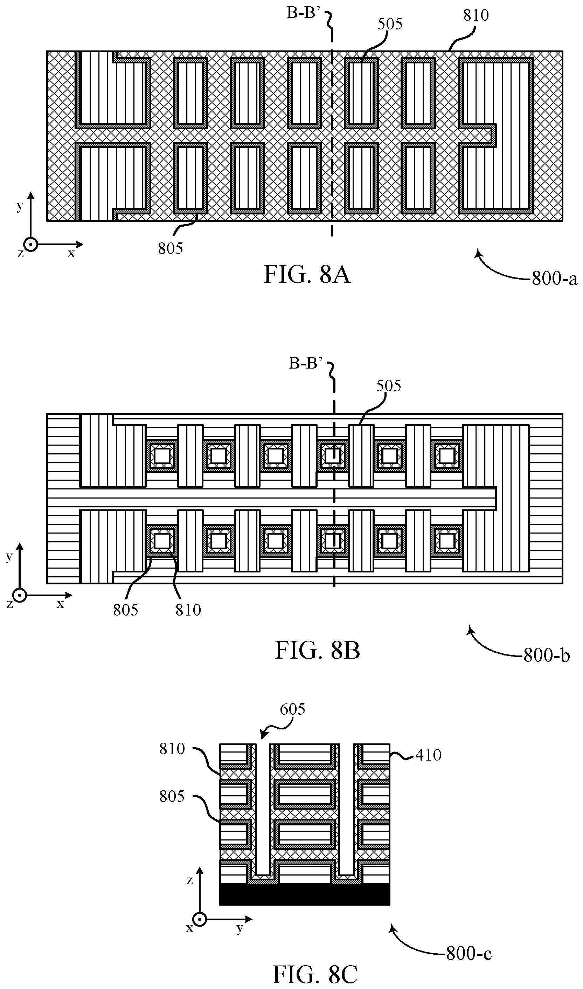

Forming the set of cavities 605 may define a set of interleaved comb structures, such as a first comb structure 620-a and a second comb structure 620-b. In some cases, each comb structure of the set of interleaved comb structure may include a set of "teeth" or tines extending horizontally (e.g., in the x-direction) from a base. The tines of the first comb structure 620-a may alternate (e.g., in the y-direction) with the tines of the second comb structure 620-b. The set of interleaved comb structures may correspond to one or more word line plates (e.g., the first comb structure 620-a may include a set of first word lines, and the second comb structure 620-b may include a set of second word lines), as described in greater detail with reference to FIGs. 8A, 8B, and 8C. In some examples, forming the set of interleaved comb structures using two etching steps (e.g., the etching of the piers 505 and the etching of the cavities 605) may reduce complexity of the manufacturing process relative to other manufacturing process which may use a greater quantity of etching steps to form a set of interleaved comb structures.

**FIG. 6B** illustrates a cross-sectional view aspects of the manufacturing process of a memory array 600-b along section line A-A', FIG. **6C** illustrates a cross-sectional view aspects of the manufacturing process of a memory array 600-b along section line B-B', and FIG. 6D illustrates a cross-sectional view aspects of the manufacturing process of a memory array 600-c along section line C-C'. FIG. 6A may illustrate the top-down view sectioned through one of the layers of the second material 415.

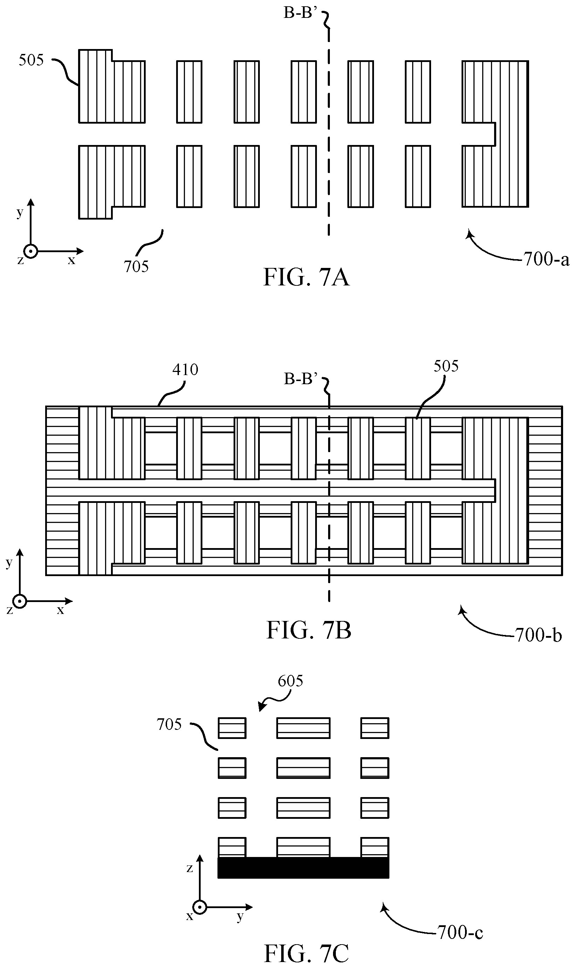

FIG. **7A, 7B, and 7C** illustrate examples of aspects of the manufacturing process of a memory array that supports cell integration for a vertical memory device in accordance with examples as disclosed herein.

**FIGs. 7A and 7B** illustrates a top-down views of aspects of the manufacturing process of a memory array 700-a. FIG. 7A illustrates a view of the memory array 700-a at a first level corresponding to the second material 415, while FIG. 7B illustrates a view of the memory array 700-b at a second level corresponding to the first material 410. Additionally, FIG. **7C** illustrates a cross-sectional view aspects of the manufacturing process of a memory array 700-c along section line B-B'.

In some cases, the manufacturing process may include removing or exhuming the second material 415 (e.g., the nitride material). For example, the second material 415 may be removed using an etching procedure (e.g., an omnidirectional etch, a horizontal etch). In some cases, the process to remove the second material 415 may be selective to the second material 415. That is, other materials of the memory array 700-a, such as the first material 410, the substrate 405, the piers 505, or any combination thereof may remain. In some cases, removing the second material 415 may leave a set of voids 705. The set of voids 705 may separate the layers of the first material 410, which may induce stress on the tines of the set of interleaved comb structures.

Accordingly, after the second material 415 has been removed, the set of piers 505 may provide mechanical support for the tines of the set of interleaved comb structures. For example, the set of piers 505 may remain in contact with the layers of the first material 410, and may prevent or reduce movement of the tines of the set of comb structures during this and subsequent steps of the manufacturing process.

**FIG. 8A, 8B, and 8C** illustrate examples of aspects of the manufacturing process of a memory array that supports cell integration for a vertical memory device in accordance with examples as disclosed herein.

**FIG. 8A** illustrates a top-down view of aspects of the manufacturing process of a memory array 800-a. In some cases, the manufacturing process may include forming a set of word lines or word line plates in the memory array 800-a. For example, the manufacturing process may include depositing one or more materials in the set of voids 705.

In some examples, an interface material, such as a barrier material 805, may be deposited into the set of voids 705. The barrier material 805 may coat or cover portions of the tines of the interleaving comb structure, as illustrated in FIG. 8C. For example, the barrier material 805 may be deposited to be in contact with the layers of the first material of the first comb structure 620-a and the second comb structure 620-b. In some cases, the barrier material 805 may be deposited in contact with at a portion of the exposed portions of the set of piers 505.

Subsequently, a conductive material 810 may be deposited in the set of voids 705. The conductive material 810 may be an example of metallic material, such as tungsten (W), and may form the conductive portion of a word line plate. In some cases, the conductive material 810 may be deposited in contact with the barrier material 805, and may fill the remaining portions of the set of voids 705. The barrier material 805 may be a conductive material, and may be a ceramic material or ceramic metal. Examples of materials for barrier material 805 include titanium nitride (TiN), titanium silicon nitride (TiSiN), tungsten nitride (WN), tungsten silicon nitride (WSiN), or other materials. The barrier material 805 may act as a barrier between the conductive material 810 and the dielectric materials, such as the first material 410 and the piers 505. The barrier material 805 and the conductive material 810 may be deposited to fill most or all of the set of voids 705. In some cases, the barrier material 805 and the conductive material 810 may fill at least a portion of each cavity of the set of cavities 605.

**FIG. 8B** illustrates a top-down view of aspects of the manufacturing process of a memory array 800-b, while FIG. **8C** illustrates a cross-sectional view aspects of the manufacturing process of a memory array 800-c along section line B-B'. The top-down view shown in FIG. 8A may correspond to a section of the stack of layers within one of the prior voids 705, while the top-down view shown in FIG. 8B may correspond to a section of the stack of layers within one of the layers of the first material 410.

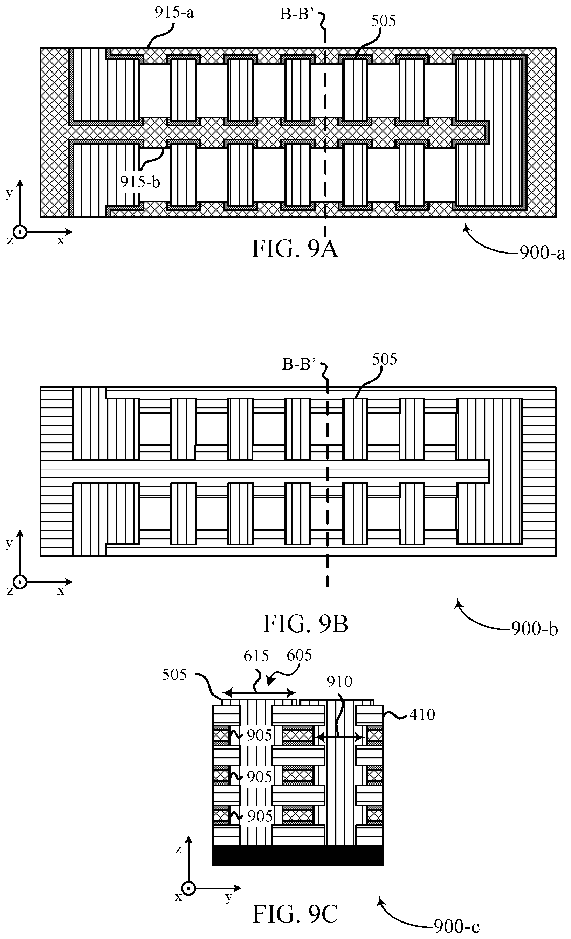

**FIG. 9A, 9B, and 9C** illustrate examples of aspects of the manufacturing process of a memory array that supports cell integration for a vertical memory device in accordance with examples as disclosed herein.

**FIG. 9A** illustrates a top-down view of aspects of the manufacturing process of a memory array 900-a. The memory array 900-a may illustrate a view at the first level (e.g., as described with reference to FIGs. 7A and 7B). In some cases, the step of the manufacturing process of the memory array 900-a may be performed subsequent to the step of the manufacturing process of the memory array 800-a as described with reference to FIG. 8A. In some cases, during the step of the manufacturing process of the memory array 900-a, at least a portion of the deposited word line materials (e.g., the barrier material 805, the conductive material 810) may be removed, for example by etching or recessing. In some examples, the recessing may recess the barrier material 805 and the conductive material 810 into the set of interleaved comb structures (e.g., as described with reference to FIG. 6A). Accordingly, the recessing may form a set of word lines or word line plates, such as a first word line 915-a (e.g., an even word line) and a second word line 915-b (e.g., an odd word line).

**FIG. 9B** illustrates a top-down view of aspects of the manufacturing process of a memory array 900-b. The memory array 900-b may illustrate a view at the second level (e.g., as described with reference to FIGs. 7A and 7B). In some examples, the recessing may expose at least portions of the layers of the first material 410. For example, the recessing may remove the barrier material 805 and the conductive material 810 from the set of cavities 605.

**FIG. 9C** illustrates a cross-sectional view aspects of the manufacturing process of a memory array 900-c along section line B-B'. As illustrated in FIG. 9C, the recessing may form a set of cavities or recesses 905 between the layers of the first material 410. In some examples, the depths of the recesses 905 (e.g., in the y-direction) may be such that the piers 505 (extended above the first material 410 for clarity) extend beyond the recesses 905. That is, the length 615 of a pier in the y-direction may be greater than a separation 910 between recesses 905 on alternate word lines. Accordingly, a memory cell in a recess 905 may experience greater mechanical stability, which may increase the likelihood of correctly forming a memory cell and thus may increase the final density of a memory array.

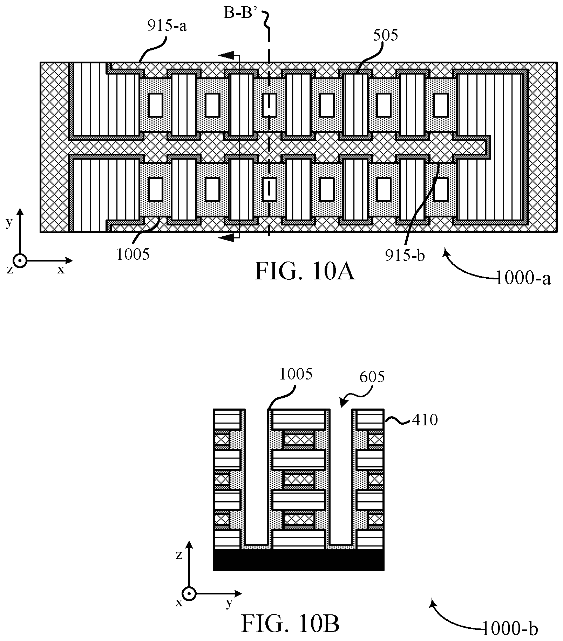

**FIG. 10A and 10B** illustrate examples of aspects of the manufacturing process of a memory array that supports cell integration for a vertical memory device in accordance with examples as disclosed herein.

**FIG. 10A** illustrates a top-down view of aspects of the manufacturing process of a memory array 1000-a. The memory array 1000-a may illustrate a view at the first level (e.g., as described with reference to FIGs. 7A and 7B). In some cases, the step of the manufacturing process of the memory array 1000-a may be performed subsequent to the step of the manufacturing process of the memory array 900-a as described with reference to FIG. 9A.

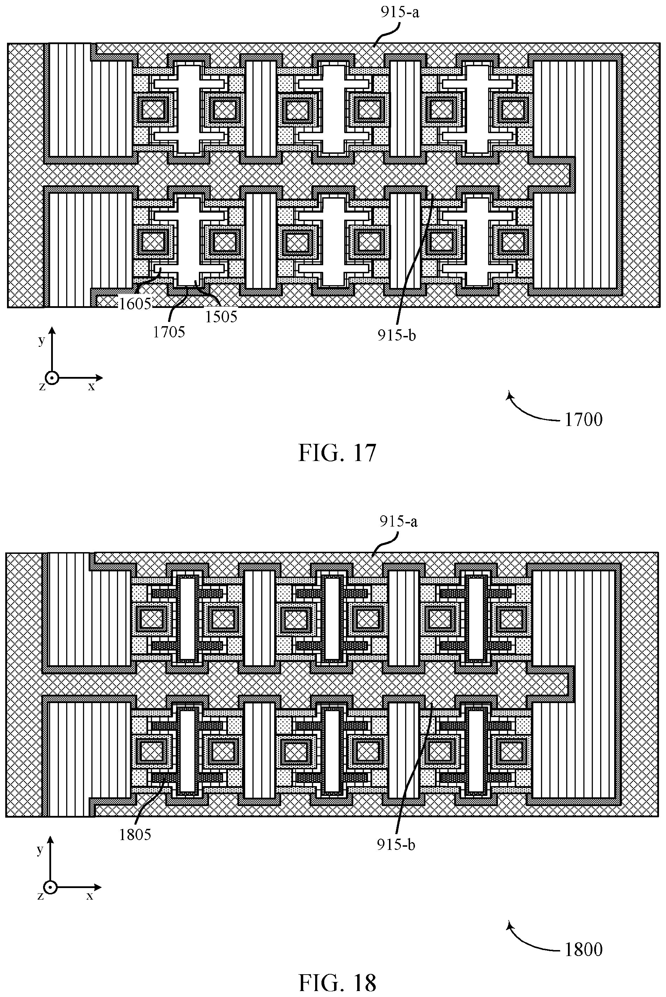

The step of the manufacturing process of the memory array 1000-a may be part of forming a memory cell at least partially in the recesses 905. In some cases, the memory cell may include an electrode material 1005 may be deposited in each cavity 605. The electrode material 1005 may be an example of a conductive material, and may allow for the flow of current between a storage component of the memory cell (described in greater detail with reference to FIG. 17) and the word line (e.g., the word line 915-a or the word line 915-b). In some examples, the electrode material 1005 may be in contact both of the interleaving comb structures. Accordingly, after being deposited, the electrode material 1005 may be in contact with both the first word line 915-a and the second word line 915-b.

In some examples, the piers 505 may act as separators for the cavities 605. For example, because the piers 505 extend beyond the cavities (e.g., in the y-direction), the piers 505 may act as a barrier for the electrode material 1005, such that the electrode material 1005 deposited in each cavity 605 are separated by respective piers 505.

**FIG. 10B** illustrates a cross-sectional view aspects of the manufacturing process of a memory array 1000-b along section line B-B'. In some cases, as illustrates in FIG. 10B, the electrode material 1005 may fill the recesses 905, and may cover the exposed substrate 405 in each cavity 605.

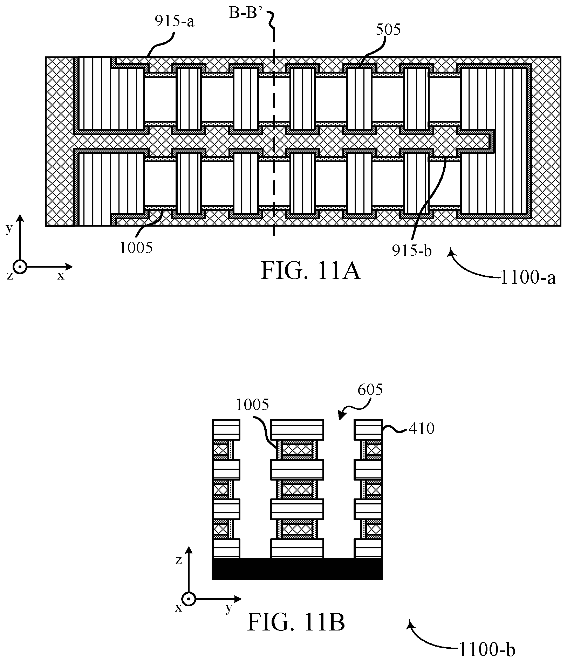

**FIG. 11A and 11B** illustrate examples of aspects of the manufacturing process of a memory array that supports cell integration for a vertical memory device in accordance with examples as disclosed herein.

**FIG. 11A** illustrates a top-down view of aspects of the manufacturing process of a memory array 1100-a. In some cases, the step of the manufacturing process of the memory array 1100-a may be performed subsequent to the step of the manufacturing process of the memory array 1000-a as described with reference to FIG. 9A. **FIG. 11B** illustrates a cross-sectional view aspects of the manufacturing process of a memory array 1100-b along section line B-B'.

**In** some cases, the manufacturing process may include a recess or etch of the electrode material 1005. For example, the electrode material 1005 may be recessed to cover a side wall of the word line plate in each recess 905. leaving a side wall of the first material 410 of each layer exposed to the cavity 605.

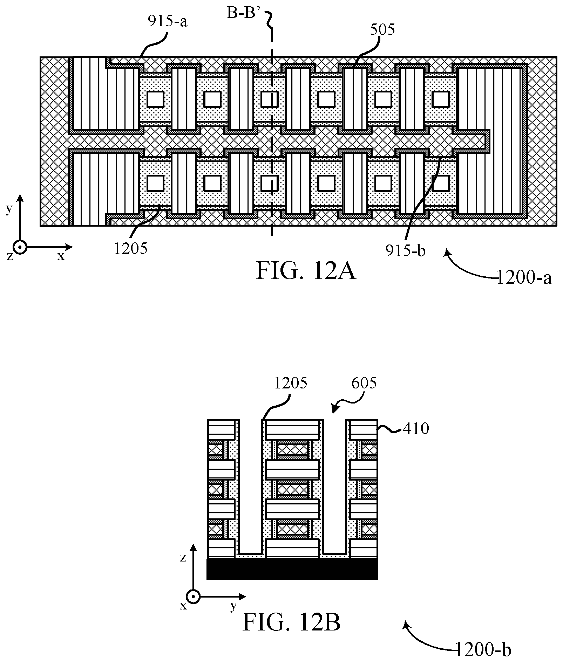

**FIG. 12A and 12B** illustrate examples of aspects of the manufacturing process of a memory array that supports cell integration for a vertical memory device in accordance with examples as disclosed herein. The memory array 1200-a may illustrate a view at the first level (e.g., as described with reference to FIGs. 7A and 7B). In some cases, the step of the manufacturing process of the memory array 1200-a may be performed subsequent to the step of the manufacturing process of the memory array 1100-a as described with reference to FIG. 11A.

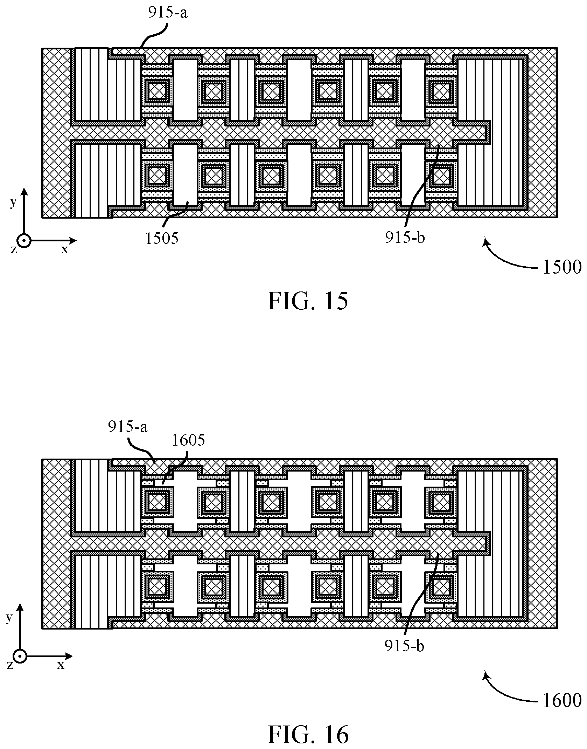

The step of the manufacturing process of the memory array 1200-a may include depositing a placeholder or sacrificial material 1205 in the set of cavities 605. In some cases, the sacrificial material 1205 may provide support prior to depositing a storage material, or may hold a place for the storage material for steps of the manufacturing process occurring prior to depositing the storage material. In such cases, at least a portion of the sacrificial material 1205 may be removed in a subsequent step of the manufacturing process, as described in greater detail with reference to FIG. 16. In some examples, the sacrificial material 1205 may be in contact both of the interleaving comb structures. Accordingly, after being deposited, the sacrificial material 1205 may be in contact with the electrode material 1005 for both the first word line 915-a and the second word line 915-b.

**In** some examples, the piers 505 may act as separators for the cavities 605. For example, because the piers 505 extend beyond the cavities (e.g., in the y-direction), the piers 505 may act as a barrier for the sacrificial material 1205, such that the sacrificial materials 1205 deposited in each cavity 605 are separated by respective piers 505.

**FIG. 12B** illustrates a cross-sectional view aspects of the manufacturing process of a memory array 1200-b along section line B-B'. In some cases, as illustrates in FIG. 12B, the sacrificial material 1205 may fill the recesses 905, and may cover the exposed substrate 405 in each cavity 605.

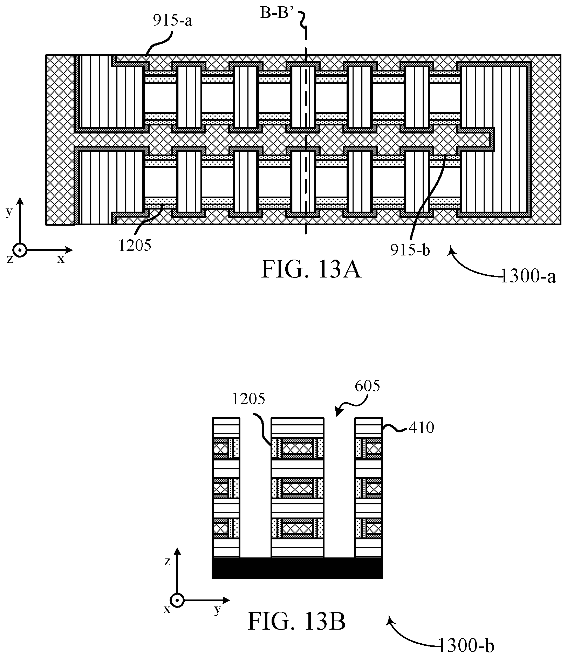

**FIGs. 13A and 13B** illustrate examples of aspects of the manufacturing process of a memory array that supports cell integration for a vertical memory device in accordance with examples as disclosed herein.

**FIG. 13A** illustrates a top-down view of aspects of the manufacturing process of a memory array 1300-a. In some cases, the step of the manufacturing process of the memory array 1300-a may be performed subsequent to the step of the manufacturing process of the memory array 1200-a as described with reference to FIG. 12A. **FIG. 13B** illustrates a cross-sectional view aspects of the manufacturing process of a memory array 1300-b along section line B-B'.

In some cases, the manufacturing process may include a recess or etch of the sacrificial material 1205. For example, the sacrificial material 1205 may be recessed to cover a side wall of the word line plate in each recess 905. leaving a side wall of the first material 410 of each layer exposed to the cavity 605.

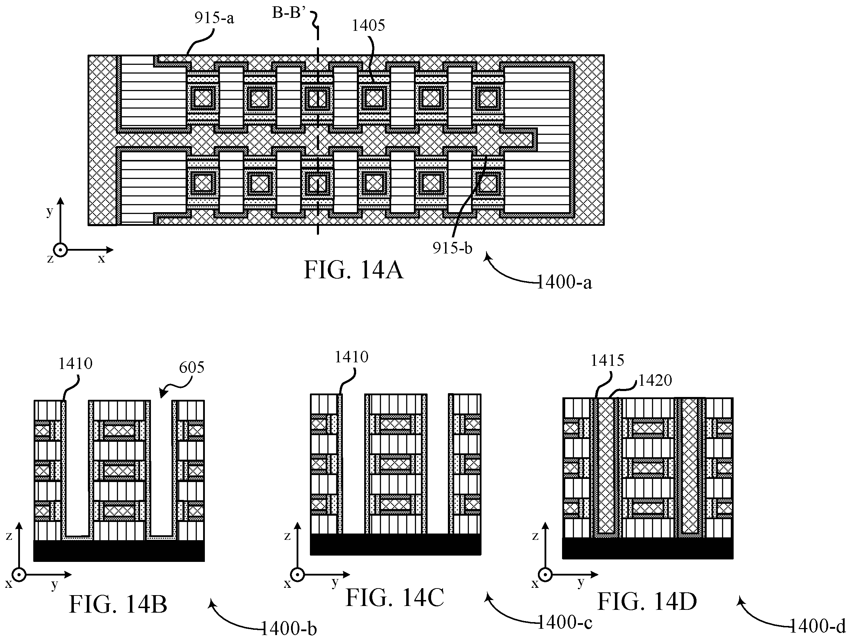

**FIG. 14A, 14B, 14C, and 14D** illustrate examples of aspects of the manufacturing process of a memory array that supports cell integration for a vertical memory device in accordance with examples as disclosed herein.

**FIG. 14A** illustrates a top-down view of aspects of the manufacturing process of a memory array 1400-a. In some cases, the memory array 1400-a may illustrate a manufacturing step in which a set of pillars 1405 are formed. The set of pillars may include an electrode material 1410, a barrier material 1415, and a conductive material 1420. In some cases, the electrode material 1410 may be the same material as the electrode material 1005, the barrier material 1415 may be the same material as the barrier material 805, and the conductive material 1420 may be the same material as the conductive material 810. The set of pillars 1405 may be coupled with bit lines (e.g., via selection transistors in substrate 405), and accordingly may be used to access a memory cells of the memory array 1400-a. In some cases, the quantity of pillars 1405 may be equal or substantially equal to the quantity of piers 505. That is, there may be approximately one pier 505 per pillar 1405, which may correspond to a dense pier aspect ratio.

In some cases, the set of pillars 1405 may be formed using one or more steps, as illustrated in FIG. 14B, 14C, and 14D. For example, FIG. **14B** illustrates a cross-sectional view aspects of the manufacturing process of a memory array 1400-b along section line B-B'. The manufacturing process may include depositing the electrode material 1410 into each of the set of cavities 605. In some cases, the electrode material 1410 may be deposited in contact with each layer of the first material 410 and the sacrificial material 1205 of each recess 905. Additionally, the electrode material 1410 may be deposited in contact with the substrate 405.

**FIG. 14C** illustrates a cross-sectional view aspects of the manufacturing process of a memory array 1400-c along section line B-B'. The manufacturing process may include etching or removing a portion of the electrode material 1410 in each cavity 605. For example, the electrode material 1410 may be etched to expose the substrate 405 in each cavity 605.

**FIG. 14D** illustrates a cross-sectional view aspects of the manufacturing process of a memory array 1400-d along section line B-B'. The manufacturing process may include depositing one or more materials in the each of the set of cavities 605. For example, manufacturing process may include depositing the barrier material 1415. In some cases, the barrier material 1415 may be deposited in contact with the electrode material 1410 on the side walls of the cavity 605. Additionally, the barrier material 1415 may be depositing in contact with the substrate 405.

The manufacturing process may further include depositing the conductive material 1420. For example, the conductive material 1420 may be depositing in contact with the barrier material 1415, and may fill the remaining portion of the cavity 605. In some cases, forming the set of pillars 1405 may further include performing a planarization process, for example, using a CMP procedure, to smooth or polish the top of the memory array 1400-a.

**FIG. 15** illustrates an example of a top-down view of aspects of a manufacturing process of a memory array 1500 that supports cell integration for a vertical memory device in accordance with examples as disclosed herein. In some cases, the step of the manufacturing process of the memory array 1500 may be performed subsequent to the step of the manufacturing process of the memory array 1400-d as described with reference to FIG. 14D.

The step of the manufacturing process of the memory array 1500 may include forming a set of cavities 1505. For example, one or more of the piers 505 may be removed to form the set of cavities 1505, for instance using a vertical etch. In some cases, removing the one or more piers 505 may expose at least one side wall of each pillar 1405, as well as at least one side wall of the electrode material 1005 and the sacrificial material 1205.

Although the example illustrated in FIG. 15 shows every other pier 505 being removed, other quantities are contemplated. For example, each pier 505 may be removed to form the set of cavities 1505. In some examples, an intermediate quantity of piers 505 may be removed (e.g., a quantity between every other pier 505 and each pier 505). In some examples, removing at least every other pier may allow for memory cell formation, as described in greater detail with reference to FIGs. 16 through 19.

**FIG. 16** illustrates an example of a top-down view of aspects of a manufacturing process of a memory array 1600 that supports cell integration for a vertical memory device in accordance with examples as disclosed herein. In some cases, the manufacturing process may include removing or etching at least a portion of the sacrificial material 1205. For example, the manufacturing process may include a lateral recess operation to remove at least a portion of the sacrificial material 1205 exposed in each cavity 1505. In some cases, removing the portion of the sacrificial material 1205 may form a set of recesses 1605 in each cavity 1505. In some cases, because at least a portion of the sacrificial material 1205 is in contact with a pier 505, each pier 505 may support a respective sacrificial material 1205 during the lateral recess.

**FIG. 17** illustrates an example of a top-down view of aspects of a manufacturing process of a memory array 1700 that supports cell integration for a vertical memory device in accordance with examples as disclosed herein. In some cases, the step of the manufacturing process of the memory array 1700 may be performed subsequent to the step of the manufacturing process of the memory array 1600 as described with reference to FIG. 16.

The step of the manufacturing process of the memory array 1700 may include depositing (e.g., adding) a storage material 1705 at a respective boundary surface of the set of cavities 1505. The storage material 1705 may be added as a thin film (e.g., using thin film deposition) at a boundary surface of a cavity 1505 (e.g., and recesses 1605) such that a remaining portion of a respective recess 1605 may separate portions of the storage material 1705. For example, based on the deposition, a first portion of the storage material 1705 may contact a sidewall of the pillar 1405 and a second portion of the storage material 1705 may contact the electrode material 1410, and the remaining portion of the recess 1605 after the deposition may form an empty area between (e.g., may separate) the first portion and the second portion.

In some cases, the storage material 1705 may be a material configured to store a logic state of a memory cell, such as a chalcogenide glass or a chalcogenide alloy. In some examples, the storage material 1705 may be in contact with both of the interleaving comb structures at the step of the manufacturing process illustrated in FIG. 17. Accordingly, after being deposited, the storage material 1705 may be in contact with both the first word line 915-a and the second word line 915-b. Additionally, the storage material 1705 may cover the exposed sidewall of each pillar 1405 (e.g., the sidewall of each pillar 1405 exposed in each cavity 1505). In some examples, the storage material 1705 may additionally cover the exposed layers of the first material 410 and the barrier material 805 (e.g., the portions exposed by the cavities 1505).

In some examples, prior to depositing the storage material 1705, the manufacturing process may include pretreating the set of cavities 1505, for example by depositing a sealing layer, or by applying a plasma treatment, such as with ammonia (NH₃).

**FIG. 18** illustrates an example of a top-down view of aspects of a manufacturing process of a memory array 1800 that supports cell integration for a vertical memory device in accordance with examples as disclosed herein. In some cases, the step of the manufacturing process of the memory array 1800 may be performed subsequent to the step of the manufacturing process of the memory array 1700 as described with reference to FIG. 17.

The step of the manufacturing process of the memory array 1800 may include depositing a sealing material 1805, which may be an example of a dielectric material, in the set of cavities 1505 (e.g., and recesses 1605). In some cases, the sealing material 1805 may be deposited in contact with the storage material 1705 of each cavity 1505. The sealing material 1805 may fill the empty area in recesses 1605 between first and second portions of the storage material 1705 (e.g., such that no remaining portion of the recesses 1605 remains after the deposition, but a remaining portion of the cavity 1505 remains).

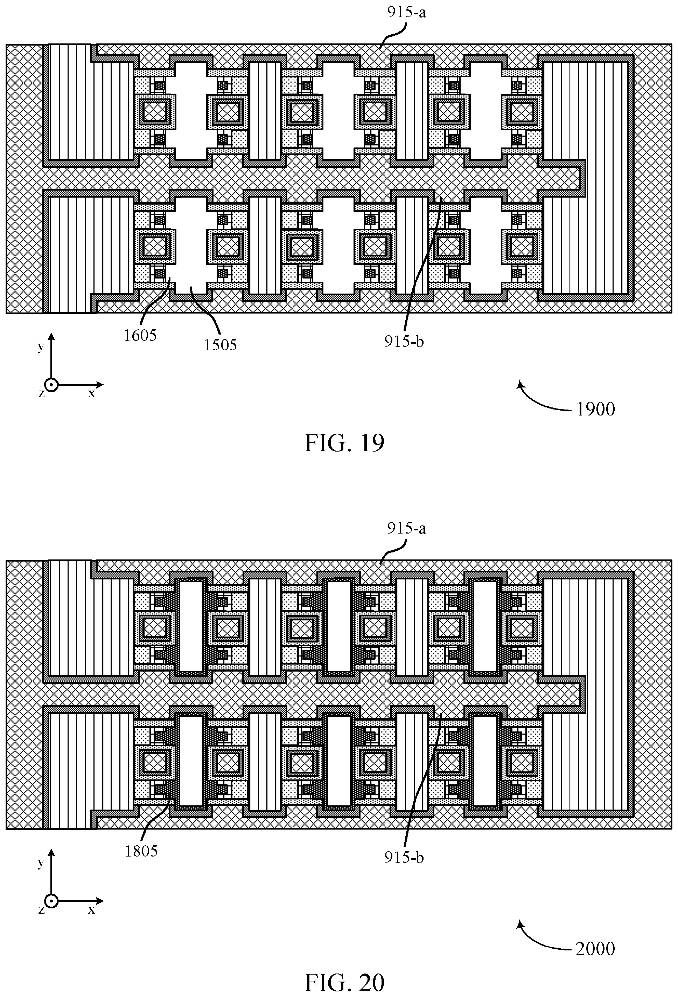

**FIG. 19** illustrates an example of a top-down view of aspects of a manufacturing process of a memory array 1900 that supports cell integration for a vertical memory device in accordance with examples as disclosed herein. In some cases, the step of the manufacturing process of the memory array 1900 may be performed subsequent to the step of the manufacturing process of the memory array 1800 as described with reference to FIG. 18.

In some cases, the manufacturing process may include a recess or etch of the storage material 1705 and the sealing material 1805. For example, the storage material 1705 and the sealing material 1805 may be recessed to form a set of memory cells in each of the cavities 1505 (e.g., one memory cell in each recess 1605 to form four memory cells per cavity). In some cases, each memory cell may be coupled with a pillar 1405 and a word line 915-a or 915-b (e.g., a single layer and tine of a comb structure of the set of interleaved comb structures).

In some cases, based on recessing the storage material 1705 and the sealing material 1805, at least a portion of the boundary surface of each cavity 1505 may be re-exposed (e.g., and a portion of each recess 1605 emptied of material). Recessing the storage material 1705 and the sealing material 1805 may include a sequential etching process, a single etching process, or both.

In some cases, based on recessing the storage material 1705 and the sealing material 1805, a length (e.g., a distance in the x-direction) of the first portion of the storage material 1705 contacting the pillar sidewall of the pillar 1405 and the second portion of the storage material 1705 contacting the electrode material 1410 may be reduced (e.g., shortened). The first portion and the second portion may have a same length (e.g., distance in the x-direction), or approximately the same length (e.g., may be flush on an exposed side).

**FIG. 20** illustrates an example of a top-down view of aspects of a manufacturing process of a memory array 2000 that supports cell integration for a vertical memory device in accordance with examples as disclosed herein.

The step of the manufacturing process of the memory array 2000 may include depositing a sealing material 1805, which may be an example of a dielectric material, in the set of cavities 1505 (e.g., and recesses 1605). For example, the sealing material 1805 may fill remaining empty areas (e.g., or spaces) in the recesses 1605 and may fill at least a portion of the remaining cavity 1505 (e.g., such that no remaining portion of the recesses 1605 remains after the deposition, but a remaining portion of the cavity 1505 remains). In some cases, the sealing material 1805 may be deposited in contact with the storage material 1705 (e.g., at the exposed surface of first and second portions of the storage material 1705) of each recess 1605 or each cavity 1505 or both. A thickness (e.g., a distance in the y-direction) of a first portion of the sealing material 1805 deposited within recesses 1605 at the step of the manufacturing process may be greater than a second portion of the sealing material 1805 previously deposited in the area between the first and second portions of the storage material 1705 (e.g., in recesses 1605).

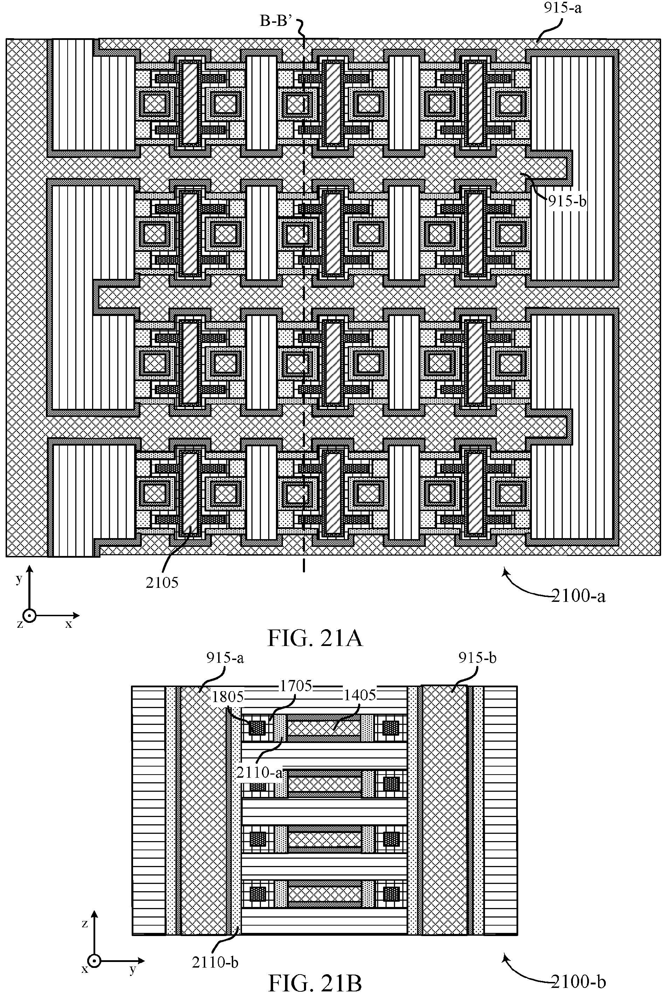

**FIGs. 21A** and **21B** illustrate examples of aspects of a manufacturing process of a memory array that supports cell integration for a vertical memory device in accordance with examples as disclosed herein.

**FIG. 21A** illustrates a top-down view of aspects of a manufacturing process of a memory array 2100-a. In some cases, the step of the manufacturing process of the memory array 2100-a may be performed subsequent to the step of the manufacturing process of the memory array 1800 as described with reference to FIG. 18 (e.g., formation of the memory array 2100-a may skip manufacturing steps illustrated in FIGs. 19-20). FIG. **21B** illustrates a cross-sectional view of aspects of a manufacturing process of a memory array 2100-b along section line B-B'. FIGs. 21A and 21B show an expanded view of the memory array 2100-a and the memory array 2100-b relative to other examples disclosed herein such that additional examples of memory cells are shown for illustration. It is to be understood that memory arrays of the other examples disclosed herein may also include these additional memory cells despite showing a limited view for illustration purposes. In general, it is to be understood that examples disclosed herein are exemplary and patterns shown in the examples described herein may be repeated any number of times elsewhere in the memory array to support formation of any number of memory cells at various locations.

The step of the manufacturing process of the memory array 2000 may include depositing a gap fill material 2105 in the set of cavities 1505. In some cases, the gap fill material 2105 may be deposited in contact with the sealing material 1805. Additionally, the gap fill material 2105 may fill the remaining portion of each of the cavities 1505. In some cases, the gap fill material 2105 may be an example of a dielectric material, such as a same material as the piers 505. Alternatively, the gap fill material 2105 may be an example of a different dielectric material.

The sealing material 1805 along with the gap fill material 2105 in each cavity 1505 may form a set of respective dielectric portions. In some cases, forming the set of dielectric portions may further include performing a planarization process, for example, using a CMP procedure, to smooth or polish the top of the memory array 2100-a. In some examples, the dielectric portions may have a length in the y direction which is greater than the length 615 of the cavities 605. That is, the dielectric portions may extend at least partially into the word lines 915-a and 915-b. Accordingly, the dielectric portions may form a single continuous surface between the word lines 915-a and 915-b.

In some examples, manufacturing a memory array, such as the memory array 2100-a, may be performed by manufacturing a set of discrete decks or tiles, which may be joined together to form a memory array. In such examples, different tiles may be isolated from each other, for example by an edge cut. In some cases, the edge cut may be performed using a pier etch (e.g., a same etch used to create the set of cavities 420).

In some examples, a cross-sectional area of piers 505 in an xy-plane may be relatively larger at distances nearer to the substrate 405 (e.g., due to taper along the z-direction resulting from an etching operation to form cavities 605), or edges of piers 505 along an x-direction, along a y-direction, or along a z-direction may be rounded or chamfered (e.g., due to material removal operations or other processing during operations after forming piers 505). In some examples, such tapering, rounding, or chamfering may be apparent at an interface between piers 505 and other materials, including electrode material 1410, barrier material 1415, or sacrificial material 1205, among other interfacing materials deposited after the formation of the piers 505. For example, an interface between piers 505 and electrode material 1410 may have a tapered profile with a positive slope (e.g., a slope that is less than vertical) of a surface of pier 505 and a negative slope (e.g., a slope that is more than vertical) of electrode material 1410 at the interface.

Memory cells of the memory array 2100-b may be formed from the storage material 1705 such that the storage material 1705 surrounds (e.g., encapsulates) the sealing material 1805 (e.g., a dielectric seal). That is, the dielectric seal may be located in an area between a first portion of the storage material 1705 and a second portion of the storage material 1705. The first portion of the storage material 1705 may contact a first electrode 2110-a (e.g., first portion of electrode material 1410), for coupling memory cells of the memory array 2100-b with the pillar 1405. The second portion of the storage material 1705 may contact a second electrode 2110-b (e.g., second portion of electrode material 1410), for coupling memory cells of the memory array 2100-b with the word line 915-a or the word line 915-b.

By forming the memory cells of the memory array 2100-a (e.g., or memory array 2100-b) according to techniques described herein, the memory array 2100-a may support a relatively smaller cell size and increased cell containment. The memory cells of the memory array 2100-a may be formed to a "cup-like" shape and may operate transversally to support storage and/or access of data to the memory cells. By enabling a relatively smaller cell size and increased cell containment, the techniques described herein may support an increased read window during access of memory cells, which may result in faster access speeds, reduced latency, and increased storage accuracy. A read window for the memory array 2100-a may refer to a time interval (e.g., a duration) between when a row is activated and before a column is selected for access, where data in the memory cell is valid and is able to be read from.

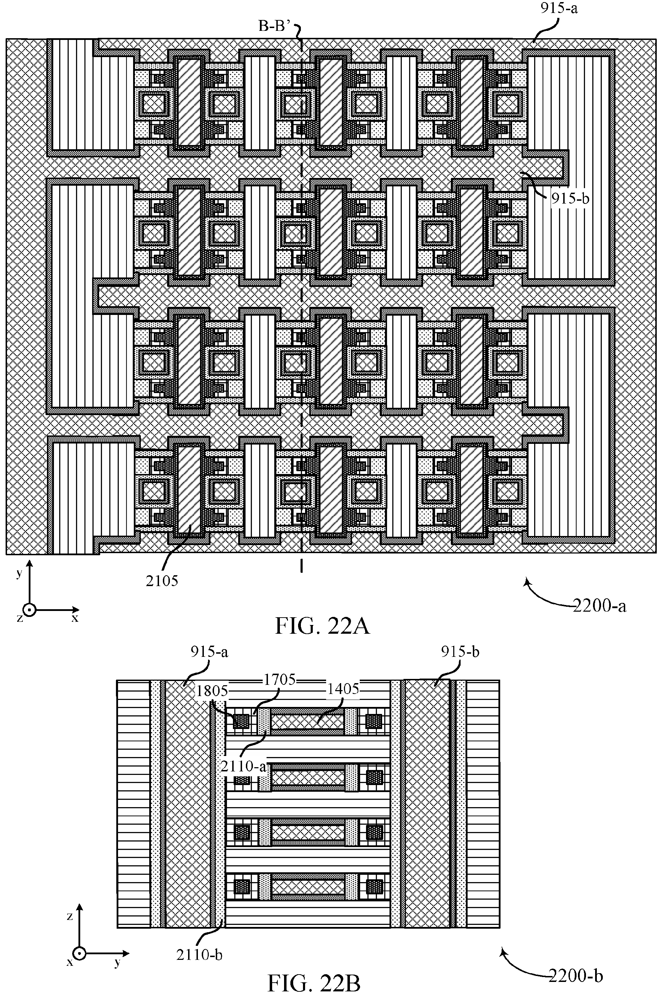

**FIGs. 22A** and **22B** illustrate examples of aspects of a manufacturing process of a memory array that supports cell integration for a vertical memory device in accordance with examples as disclosed herein.

**FIG. 22A** illustrates a top-down view of aspects of a manufacturing process of a memory array 2200-a. In some cases, the step of the manufacturing process of the memory array 2200-a may be performed subsequent to the step of the manufacturing process of the memory array 2000 as described with reference to FIG. 20. FIG. 22B illustrates a cross-sectional view aspects of a manufacturing process of a memory array 2200-b along section line B-B'. FIGs. 22A and 22B show an expanded view of the memory array 2100-a and the memory array 2100-b relative to other examples disclosed herein such that additional examples of memory cells are shown for illustration. It is to be understood that memory arrays of the other examples disclosed herein may also include these additional memory cells despite showing a limited view for illustration purposes. In general, it is to be understood that examples disclosed herein are exemplary and patterns shown in the examples described herein may be repeated any number of times elsewhere in the memory array to support formation of any number of memory cells at various locations.

The step of the manufacturing process of the memory array 2000 may include depositing a gap fill material 2105 in the set of cavities 1505. In some cases, the gap fill material 2105 may be deposited in contact with the sealing material 1805. Additionally, the gap fill material 2105 may fill the remaining portion of each of the cavities 1505. In some cases, the gap fill material 2105 may be an example of a dielectric material, such as a same material as the piers 505. Alternatively, the gap fill material 2105 may be an example of a different dielectric material.

The sealing material 1805 along with the gap fill material 2105 in each cavity 1505 may form a set of respective dielectric portions. In some cases, forming the set of dielectric portions may further include performing a planarization process, for example, using a CMP procedure, to smooth or polish the top of the memory array 2000. In some examples, the dielectric portions may have a length in the y direction which is greater than the length 615 of the cavities 605. That is, the dielectric portions may extend at least partially into the word lines 915-a and 915-b. Accordingly, the dielectric portions may form a single continuous surface between the word lines 915-a and 915-b.

In some examples, manufacturing a memory array, such as the memory array 2000, may be performed by manufacturing a set of discrete decks or tiles, which may be joined together to form a memory array. In such examples, different tiles may be isolated from each other, for example by an edge cut. In some cases, the edge cut may be performed using a pier etch (e.g., a same etch used to create the set of cavities 420).

In some examples, a cross-sectional area of piers 505 in an xy-plane may be relatively larger at distances nearer to the substrate 405 (e.g., due to taper along the z-direction resulting from an etching operation to form cavities 605), or edges of piers 505 along an x-direction, along a y-direction, or along a z-direction may be rounded or chamfered (e.g., due to material removal operations or other processing during operations after forming piers 505). In some examples, such tapering, rounding, or chamfering may be apparent at an interface between piers 505 and other materials, including electrode material 1410, barrier material 1415, or sacrificial material 1205, among other interfacing materials deposited after the formation of the piers 505. For example, an interface between piers 505 and electrode material 1410 may have a tapered profile with a positive slope (e.g., a slope that is less than vertical) of a surface of pier 505 and a negative slope (e.g., a slope that is more than vertical) of electrode material 1410 at the interface.

Memory cells of the memory array 2100-b may be formed from the storage material 1705 such that the storage material 1705 surrounds (e.g., encapsulates) the sealing material 1805 (e.g., a dielectric seal). That is, the dielectric seal may be located in an area between a first portion of the storage material 1705 and a second portion of the storage material 1705. The first portion of the storage material 1705 may contact a first electrode 2110-a (e.g., first portion of electrode material 1410), for coupling memory cells of the memory array 2100-b with the pillar 1405. The second portion of the storage material 1705 may contact a second electrode 2110-b (e.g., second portion of electrode material 1410), for coupling memory cells of the memory array 2100-b with the word line 915-a or the word line 915-b.

By forming the memory cells of the memory array 2200-a (e.g., or memory array 2200-b) according to techniques described herein, the memory array 2200-a may support a relatively smaller cell size and increased cell containment (e.g., a smaller cell size and increased cell containment relative to the memory array 2100-a). The memory cells of the memory array 2100-a may be formed to a "cup-like" shape and may operate transversally to support storage and/or access of data to the memory cells. By enabling a relatively smaller cell size and increased cell containment, the techniques described herein may support an increased read window during access of memory cells, which may result in faster access speeds, reduced latency, and increased storage accuracy.

**FIGs. 23A** and **23B** show a flowchart illustrating a method 2300 that supports cell integration for a vertical memory device in accordance with examples as disclosed herein. The operations of method 2300 may be implemented by a manufacturing system or its components as described herein. For example, the operations of method 2300 may be performed by a manufacturing system as described with reference to FIGs. 1 through 22. In some examples, a manufacturing system may execute a set of instructions to control the functional elements of the device to perform the described functions. Additionally, or alternatively, the manufacturing system may perform aspects of the described functions using special-purpose hardware.

At 2305, the method may include forming a plurality of piers through a stack of layers including a first material and a second material based at least in part on forming a first plurality of cavities through the stack of layers and filling the first plurality of cavities with a third material.

At 2310, the method may include forming a second plurality of cavities through the stack of layers.

At 2315, the method may include forming a plurality of first word lines and a plurality of second word lines based at least in part on removing the second material to form an interleaved pair of comb structures including the first material and adjacent to a first plurality of voids.

At 2320, the method may include adding an electrode material in each cavity of the second plurality of cavities, the electrode material in contact with a first word line of the plurality of first word lines or a second word line of the plurality of second word lines.

At 2325, the method may include forming a plurality of pillars in the second plurality of cavities based at least in part on depositing a conductive material in the second plurality of cavities.

At 2330, the method may include forming a third plurality of cavities between the plurality of pillars based at least in part on removing at least a subset of piers of the plurality of piers and one or more portions of a sacrificial material in each cavity of the second plurality of cavities and in contact with the electrode material, each cavity of the third plurality of cavities exposing a respective first sidewall and one or more portions of respective second and third sidewalls of a pillar of the plurality of pillars.

At 2335, the method may include adding a memory material at a boundary surface of each cavity of the third plurality of cavities, where a respective first portion of the memory material contacts one of the respective second and third sidewalls of a pillar of the plurality of pillars and a respective second portion of the memory material contacts the electrode material, where a remaining portion of each cavity of the third plurality of cavities includes an area between the respective first portion of the memory material and the respective second portion of the memory material based at least in part on adding the memory material at the boundary surface.

At 2340, the method may include forming a plurality of memory cells based at least in part on adding the memory material at the boundary surface of each cavity of the third plurality of cavities, each memory cell of the plurality of memory cells coupled, via the electrode material, between a pillar of the plurality of pillars and a word line of the plurality of first word lines or the plurality of second word lines.

At 2345, the method may include forming a plurality of dielectric seals based at least in part on adding a dielectric material in the remaining portion of each cavity of the third plurality of cavities, the plurality of dielectric seals filling the area between the respective first portion of the memory material and the respective second portion of the memory material.

In some examples, an apparatus as described herein may perform a method or methods, such as the method 2300. The apparatus may include features, circuitry, logic, means, or instructions (e.g., a non-transitory computer-readable medium storing instructions executable by a processor), or any combination thereof for performing the following aspects of the present disclosure:
Aspect 1: A method or apparatus including operations, features, circuitry, logic, means, or instructions, or any combination thereof for forming a plurality of piers through a stack of layers including a first material and a second material based at least in part on forming a first plurality of cavities through the stack of layers and filling the first plurality of cavities with a third material; forming a second plurality of cavities through the stack of layers; forming a plurality of first word lines and a plurality of second word lines based at least in part on removing the second material to form an interleaved pair of comb structures including the first material and adjacent to a first plurality of voids; adding an electrode material in each cavity of the second plurality of cavities, the electrode material in contact with a first word line of the plurality of first word lines or a second word line of the plurality of second word lines; adding, in each cavity of the second plurality of cavities, a sacrificial material in contact with the electrode material; forming a plurality of pillars in the second plurality of cavities based at least in part on depositing a conductive material in the second plurality of cavities; forming a third plurality of cavities between the plurality of pillars based at least in part on removing at least a subset of piers of the plurality of piers and one or more portions of the sacrificial material, each cavity of the third plurality of cavities exposing a respective first sidewall and one or more portions of respective second and third sidewalls of a pillar of the plurality of pillars; adding a memory material at a boundary surface of each cavity of the third plurality of cavities, where a respective first portion of the memory material contacts one of the respective second and third sidewalls of a pillar of the plurality of pillars and a respective second portion of the memory material contacts the electrode material, where a remaining portion of each cavity of the third plurality of cavities includes an area between the respective first portion of the memory material and the respective second portion of the memory material based at least in part on adding the memory material at the boundary surface; forming a plurality of memory cells based at least in part on adding the memory material at the boundary surface of each cavity of the third plurality of cavities, each memory cell of the plurality of memory cells coupled, via the electrode material, between a pillar of the plurality of pillars and a word line of the plurality of first word lines or the plurality of second word lines; and forming a plurality of dielectric seals based at least in part on adding a dielectric material in the remaining portion of each cavity of the third plurality of cavities, the plurality of dielectric seals filling the area between the respective first portion of the memory material and the respective second portion of the memory material.
Aspect 2: The method or apparatus of aspect 1, further including operations, features, circuitry, logic, means, or instructions, or any combination thereof for forming, after forming the plurality of dielectric seals, a plurality of dielectric portions based at least in part on adding a second dielectric material to fill the remaining portion of each cavity of the third plurality of cavities.
Aspect 3: The method or apparatus of any of aspects 1 through 2, further including operations, features, circuitry, logic, means, or instructions, or any combination thereof for removing, after forming the plurality of dielectric seals, a portion of the memory material and a portion of the dielectric material, where at least a portion of the boundary surface of each cavity of the third plurality of cavities is re-exposed after removing the portion of the memory material and the portion of the dielectric material and adding the dielectric material in the remaining portion of each cavity of the third plurality of cavities after removing the portion of the memory material and the portion of the dielectric material, the dielectric material contacting at least the re-exposed portion of the boundary surface.
Aspect 4: The method or apparatus of aspect 3, where removing the portion of the memory material and the portion of the dielectric material includes reducing a distance of the respective first portion of the memory material and the respective second portion of the memory material and a respective size of each memory cell the plurality of memory cells is in accordance with the reduced distance of the respective first portion of the memory material and the respective second portion of the memory material.
Aspect 5: The method or apparatus of any of aspects 3 through 4, where after removing the portion of the memory material and the portion of the dielectric material, a first distance of the respective first portion of the memory material and a second distance of the respective second portion of the memory material are a same distance.
Aspect 6: The method or apparatus of any of aspects 3 through 5, where removing the portion of the memory material and the portion of the dielectric material is in accordance with a sequential etching process, a single etching process, or both.
Aspect 7: The method or apparatus of any of aspects 1 through 6, where removing at least the subset of piers of the plurality of piers includes removing alternating piers of the plurality of piers.
Aspect 8: The method or apparatus of any of aspects 1 through 7, further including operations, features, circuitry, logic, means, or instructions, or any combination thereof for adding the stack of layers over a substrate, the stack of layers including the layers of the first material and the second material, where the first material includes a second dielectric material.
Aspect 9: The method or apparatus of any of aspect 8, where the third material of the plurality of piers includes a third dielectric material different than the second dielectric material.
Aspect 10: The method or apparatus of any of aspects 1 through 9, where forming the plurality of first word lines and the plurality of second word lines includes operations, features, circuitry, logic, means, or instructions, or any combination thereof for adding a second conductive material in the first plurality of voids.
Aspect 11: The method or apparatus of any of aspects 1 through 10, where the memory material includes a chalcogenide material.
Aspect 12: The method or apparatus of any of aspects 1 through 11, where each of the layers of the first material and the second material is in contact with each pier of the plurality of piers.

It should be noted that the methods described herein describe possible implementations, and that the operations and the steps may be rearranged or otherwise modified and that other implementations are possible. Further, portions from two or more of the methods may be combined.

An apparatus is described. The following provides an overview of aspects of the apparatus as described herein:
Aspect 13: An apparatus, including: a substrate; a plurality of first word lines extending in a first direction relative to the substrate, where each of the plurality of first word lines includes a plurality of first word line portions extending in a second direction relative to the substrate, the plurality of first word lines separated from each other by a dielectric material extending in the first direction; a plurality of conductive pillars, the plurality of first word line portions positioned between a pair of conductive pillars of the plurality of conductive pillars; a plurality of dielectric structures extending in the first direction, each dielectric structure of the plurality of dielectric structures in contact with a respective first word line portion of the plurality of first word line portions for each of the plurality of first word lines and in contact with a respective second word line portion of a plurality of second word line portions for each of a plurality of second word lines, where a distance between a portion of the respective first word line portion in contact with a dielectric structure and a portion of the respective second word line portion in contact with the dielectric structure includes a first distance along a third direction; and a first plurality of memory cells that are each coupled, via a first electrode, with a respective word line portion of the plurality of first word line portions and coupled, via a second electrode, with a first pillar of the pair of conductive pillars, where a memory material of each memory cell of the first plurality of memory cells surrounds a first dielectric seal, the first dielectric seal located in an area between a first portion of the memory material contacting the first electrode and a second portion of the memory material contacting the second electrode.
Aspect 14: The apparatus of aspect 13, further including: a second plurality of memory cells that are each coupled, via a third electrode, with a respective word line portion of the plurality of second word line portions and coupled, via a fourth electrode, with a second pillar of the pair of conductive pillars, where the memory material of each memory cell of the second plurality of memory cells surrounds a second dielectric seal, the second dielectric seal located in an area between a third portion of the memory material contacting the third electrode and a fourth portion of the memory material contacting the fourth electrode.
Aspect 15: The apparatus of any of aspects 13 through 14, where a distance of the first portion of the memory material contacting the first electrode and a distance of the second portion of the memory material contacting the second electrode are a same distance.
Aspect 16: The apparatus of any of aspects 13 through 15, where a distance between a portion of the respective first word line portion not in contact with the dielectric structure and a portion of the respective second word line portion not in contact with the dielectric structure includes a second distance along the third direction that is greater than the first distance.
Aspect 17: The apparatus of any of aspects 13 through 16, where the plurality of dielectric structures includes: a first plurality of dielectric portions between a first plurality of adjacent pairs of the plurality of conductive pillars, each of the first plurality of dielectric portions having sidewalls including a single continuous surface between the plurality of first word line portions and the plurality of second word line portions; and a second plurality of dielectric portions between a second plurality of adjacent pairs of the plurality of conductive pillars, each of the second plurality of dielectric portions including extensions that extend at least partially between a conductive pillar of the plurality of conductive pillars and the plurality of first word line portions and at least partially between the conductive pillar and the plurality of second word line portions.
Aspect 18: The apparatus of aspect 17, where each of the extensions of the second plurality of dielectric portions is in contact with one or more of the first plurality of memory cells or one or more of a second plurality of memory cells.
Aspect 19: The apparatus of any of aspects 17 through 18, where each of the second plurality of dielectric portions includes the memory material, a dielectric seal material, and an oxide material.
Aspect 20: The apparatus of aspect 19, where the memory material forms a perimeter around the second plurality of dielectric portions and surrounds the dielectric seal material.
Aspect 21: The apparatus of any of aspects 19 through 20, where the dielectric seal material forms a perimeter around the second plurality of dielectric portions.

An apparatus is described. The following provides an overview of aspects of the apparatus as described herein:
Aspect 22: An apparatus having a memory array formed by a process including: forming a plurality of piers through a stack of layers including a first material and a second material based at least in part on forming a first plurality of cavities through the stack of layers and filling the first plurality of cavities with a third material; forming a plurality of first word lines and a plurality of second word lines based at least in part on removing the second material to form an interleaved pair of comb structures including the first material and adjacent to a first plurality of voids; forming a second plurality of cavities through the stack of layers; adding an electrode material in each cavity of the second plurality of cavities, the electrode material in contact with a first word line of the plurality of first word lines or a second word line of the plurality of second word lines; adding, in each cavity of the second plurality of cavities, a sacrificial material in contact with the electrode material; forming a plurality of pillars in the second plurality of cavities; forming a third plurality of cavities between the plurality of pillars based at least in part on removing at least a subset of piers of the plurality of piers and one or more portions of the sacrificial material, each cavity of the third plurality of cavities exposing a respective first sidewall and one or more portions of respective second and third sidewalls of a pillar of the plurality of pillars; adding a memory material at a boundary surface of each cavity of the third plurality of cavities, where a respective first portion of the memory material contacts one of the respective second and third sidewalls of a pillar of the plurality of pillars and a respective second portion of the memory material contacts the electrode material, where a remaining portion of each cavity of the third plurality of cavities includes an area between the respective first portion of the memory material and the respective second portion of the memory material based at least in part on adding the memory material at the boundary surface; forming a plurality of memory cells based at least in part on adding the memory material at the boundary surface of each cavity of the third plurality of cavities, each memory cell of the plurality of memory cells coupled, via the electrode material, between a pillar of the plurality of pillars and a word line of the plurality of first word lines or the plurality of second word lines; and forming a plurality of dielectric seals based at least in part on adding a dielectric material in the remaining portion of each cavity of the third plurality of cavities, the plurality of dielectric seals filling the area between the respective first portion of the memory material and the respective second portion of the memory material.
Aspect 23: The apparatus of aspect 22, where the process further includes: forming, after forming the plurality of dielectric seals, a plurality of dielectric portions based at least in part on adding a second dielectric material in the remaining portion of each cavity of the third plurality of cavities.
Aspect 24: The apparatus of any of aspects 22 through 23, where the process further includes: removing, after forming the plurality of dielectric seals, a portion of the memory material and a portion of the dielectric material, where at least a portion of the boundary surface of each cavity of the third plurality of cavities is re-exposed after removing the portion of the memory material and the portion of the dielectric material; and adding the dielectric material in the remaining portion of each cavity of the third plurality of cavities after removing the portion of the memory material and the portion of the dielectric material, the dielectric material contacting at least the re-exposed portion of the boundary surface.
Aspect 25: The apparatus of aspect 24, where removing the portion of the memory material and the portion of the dielectric material includes shortening a distance of the respective first portion of the memory material and the respective second portion of the memory material, a respective size of each memory cell the plurality of memory cells is in accordance with the shortened distance of the respective first portion of the memory material and the respective second portion of the memory material.

Information and signals described herein may be represented using any of a variety of different technologies and techniques. For example, data, instructions, commands, information, signals, bits, or symbols of signaling that may be referenced throughout the above description may be represented by voltages, currents, electromagnetic waves, magnetic fields or particles, optical fields or particles, or any combination thereof. Some drawings may illustrate signals as a single signal; however, the signal may represent a bus of signals, where the bus may have a variety of bit widths.

The terms "electronic communication," "conductive contact," "connected," and "coupled" may refer to a relationship between components that supports the flow of signals between the components. Components are considered in electronic communication with (or in conductive contact with or connected with or coupled with) one another if there is any conductive path between the components that can, at any time, support the flow of signals between the components. At any given time, the conductive path between components that are in electronic communication with each other (or in conductive contact with or connected with or coupled with) may be an open circuit or a closed circuit based on the operation of the device that includes the connected components. The conductive path between connected components may be a direct conductive path between the components or the conductive path between connected components may be an indirect conductive path that may include intermediate components, such as switches, transistors, or other components. In some examples, the flow of signals between the connected components may be interrupted for a time, for example, using one or more intermediate components such as switches or transistors.

The term "coupling" (e.g., "electrically coupling") may refer to condition of moving from an open-circuit relationship between components in which signals are not presently capable of being communicated between the components over a conductive path to a closed-circuit relationship between components in which signals are capable of being communicated between components over the conductive path. When a component, such as a controller, couples other components together, the component initiates a change that allows signals to flow between the other components over a conductive path that previously did not permit signals to flow.

The term "isolated" refers to a relationship between components in which signals are not presently capable of flowing between the components. Components are isolated from each other if there is an open circuit between them. For example, two components separated by a switch that is positioned between the components are isolated from each other when the switch is open. When a controller isolates two components, the controller affects a change that prevents signals from flowing between the components using a conductive path that previously permitted signals to flow.

The term "layer" or "level" used herein refers to a stratum or sheet of a geometrical structure (e.g., relative to a substrate). Each layer or level may have three dimensions (e.g., height, width, and depth) and may cover at least a portion of a surface. For example, a layer or level may be a three-dimensional structure where two dimensions are greater than a third, e.g., a thin-film. Layers or levels may include different elements, components, or materials. In some examples, one layer or level may be composed of two or more sublayers or sublevels.

As used herein, the term "electrode" may refer to an electrical conductor, and in some examples, may be employed as an electrical contact to a memory cell or other component of a memory array. An electrode may include a trace, wire, conductive line, conductive layer, or the like that provides a conductive path between elements or components of a memory array.

The devices discussed herein, including a memory array, may be formed on a semiconductor substrate, such as silicon, germanium, silicon-germanium alloy, gallium arsenide, gallium nitride, etc. In some examples, the substrate is a semiconductor wafer. In other examples, the substrate may be a silicon-on-insulator (SOI) substrate, such as silicon-on-glass (SOG) or silicon-on-sapphire (SOS), or epitaxial layers of semiconductor materials on another substrate. The conductivity of the substrate, or sub-regions of the substrate, may be controlled through doping using various chemical species including, but not limited to, phosphorus, boron, or arsenic. Doping may be performed during the initial formation or growth of the substrate, by ion-implantation, or by any other doping means.

A switching component or a transistor discussed herein may represent a field-effect transistor (FET) and comprise a three terminal device including a source, drain, and gate. The terminals may be connected to other electronic elements through conductive materials, e.g., metals. The source and drain may be conductive and may comprise a heavily-doped, e.g., degenerate, semiconductor region. The source and drain may be separated by a lightly-doped semiconductor region or channel. If the channel is n-type (i.e., majority carriers are electrons), then the FET may be referred to as a n-type FET. If the channel is p-type (i.e., majority carriers are holes), then the FET may be referred to as a p-type FET. The channel may be capped by an insulating gate oxide. The channel conductivity may be controlled by applying a voltage to the gate. For example, applying a positive voltage or negative voltage to an n-type FET or a p-type FET, respectively, may result in the channel becoming conductive. A transistor may be "on" or "activated" when a voltage greater than or equal to the transistor's threshold voltage is applied to the transistor gate. The transistor may be "off" or "deactivated" when a voltage less than the transistor's threshold voltage is applied to the transistor gate.

The description set forth herein, in connection with the appended drawings, describes example configurations and does not represent all the examples that may be implemented or that are within the scope of the claims. The term "exemplary" used herein means "serving as an example, instance, or illustration," and not "preferred" or "advantageous over other examples." The detailed description includes specific details to provide an understanding of the described techniques. These techniques, however, may be practiced without these specific details. In some instances, well-known structures and devices are shown in block diagram form to avoid obscuring the concepts of the described examples.

In the appended figures, similar components or features may have the same reference label. Further, various components of the same type may be distinguished by following the reference label by a dash and a second label that distinguishes among the similar components. If just the first reference label is used in the specification, the description is applicable to any one of the similar components having the same first reference label irrespective of the second reference label.

The functions described herein may be implemented in hardware, instructions (e.g., code, software, firmware, logic) executed by a processing system (e.g., one or more processors, one or more controllers, control circuitry, processing circuitry, logic circuitry), or any combination thereof that is configured to cause a respective apparatus, device, or system to perform the described functions. If implemented as instructions executed by a processing system, the functions may be stored on or transmitted over as one or more instructions on a computer-readable medium. Due to the nature of software, functions described herein can be implemented using software executed by a processing system, hardware, firmware, hardwiring, or combinations of any of these. Features implementing functions may be physically located at various positions, including being distributed such that portions of functions are implemented at different physical locations.

Illustrative blocks and modules described herein may be implemented or performed with one or more processors, such as a DSP, an ASIC, an FPGA, discrete gate logic, discrete transistor logic, discrete hardware components, other programmable logic device, or any combination thereof, that are configured to cause the performance of the functions described herein. A processor may be an example of a microprocessor, a controller, a microcontroller, a state machine, or other types of processors. A processor may also be implemented as at least one of one or more computing devices (e.g., a combination of a DSP and a microprocessor, multiple microprocessors, one or more microprocessors in conjunction with a DSP core, or any other such configuration).

As used herein, including in the claims, "or" as used in a list of items (for example, a list of items prefaced by a phrase such as "at least one of' or "one or more of') indicates an inclusive list such that, for example, a list of at least one of A, B, or C means A or B or C or AB or AC or BC or ABC (i.e., A and B and C). Also, as used herein, the phrase "based on" shall not be construed as a reference to a closed set of conditions. For example, an exemplary step that is described as "based on condition A" may be based on both a condition A and a condition B without departing from the scope of the present disclosure. In other words, as used herein, the phrase "based on" shall be construed in the same manner as the phrase "based at least in part on."

As used herein, including in the claims, the article "a" before a noun is openended and understood to refer to "at least one" of those nouns or "one or more" of those nouns. Thus, the terms "a," "at least one," "one or more," "at least one of one or more" may be interchangeable. For example, if a claim recites "a component" that performs one or more functions, each of the individual functions may be performed by a single component or by any combination of multiple components. Thus, the term "a component" having characteristics or performing functions may refer to "at least one of one or more components" having a particular characteristic or performing a particular function. Subsequent reference to a component introduced with the article "a" using the terms "the" or "said" may refer to any or all of the one or more components. For example, a component introduced with the article "a" may be understood to mean "one or more components," and referring to "the component" subsequently in the claims may be understood to be equivalent to referring to "at least one of the one or more components." Similarly, subsequent reference to a component introduced as "one or more components" using the terms "the" or "said" may refer to any or all of the one or more components. For example, referring to "the one or more components" subsequently in the claims may be understood to be equivalent to referring to "at least one of the one or more components."

Computer-readable media includes both non-transitory computer storage media and communication media including any medium that facilitates transfer of a computer program from one place to another. A non-transitory storage medium may be any available medium, or combination of multiple media, which can be accessed by a computer. By way of example, and not limitation, non-transitory computer-readable media can comprise RAM, ROM, electrically erasable programmable read-only memory (EEPROM), optical disk storage, magnetic disk storage or other magnetic storage devices, or any other non-transitory medium or combination of media that can be used to carry or store desired program code means in the form of instructions or data structures and that can be accessed by a computer, or one or more processors.

The description herein is provided to enable a person skilled in the art to make or use the disclosure. Various modifications to the disclosure will be apparent to those skilled in the art, and the generic principles defined herein may be applied to other variations without departing from the scope of the disclosure. Thus, the disclosure is not limited to the examples and designs described herein but is to be accorded the broadest scope consistent with the principles and novel features disclosed herein.

## Claims

1. An apparatus, comprising:
a substrate;
a plurality of first word lines extending in a first direction relative to the substrate and separated from each other by a dielectric material extending in the first direction, wherein each of the plurality of first word lines comprises a plurality of first word line portions extending in a second direction relative to the substrate;
a plurality of conductive pillars, the plurality of first word line portions positioned between a pair of conductive pillars of the plurality of conductive pillars;
a plurality of dielectric structures extending in the first direction, each dielectric structure of the plurality of dielectric structures in contact with a respective first word line portion of the plurality of first word line portions and in contact with a respective second word line portion of a plurality of second word line portions for each of a plurality of second word lines; and
a first plurality of memory cells each coupled, via a first electrode, with a respective word line portion of the plurality of first word line portions and each coupled, via a second electrode, with a first pillar of the pair of conductive pillars, wherein a memory material of each memory cell of the first plurality of memory cells surrounds a first dielectric seal located in an area between a first portion of the memory material contacting the first electrode and a second portion of the memory material contacting the second electrode.

2. The apparatus of claim 1, further comprising:
a second plurality of memory cells that are each coupled, via a third electrode, with a respective word line portion of the plurality of second word line portions and coupled, via a fourth electrode, with a second pillar of the pair of conductive pillars, wherein the memory material of each memory cell of the second plurality of memory cells surrounds a second dielectric seal, the second dielectric seal located in an area between a third portion of the memory material contacting the third electrode and a fourth portion of the memory material contacting the fourth electrode.

3. The apparatus of either of claims 1 or 2, wherein a distance of the first portion of the memory material contacting the first electrode and a distance of the second portion of the memory material contacting the second electrode are a same distance.

4. The apparatus of any preceding claim, wherein a distance along a third direction is between a portion of the respective first word line portion in contact with a dielectric structure and a portion of the respective second word line portion in contact with the dielectric structure, and wherein a distance between a portion of the respective first word line portion not in contact with the dielectric structure and a portion of the respective second word line portion not in contact with the dielectric structure comprises a second distance along the third direction that is greater than a first distance.

5. The apparatus of any preceding claim, wherein the plurality of dielectric structures comprises:
a first plurality of dielectric portions between a first plurality of adjacent pairs of the plurality of conductive pillars, each of the first plurality of dielectric portions having sidewalls comprising a single continuous surface between the plurality of first word line portions and the plurality of second word line portions; and
a second plurality of dielectric portions between a second plurality of adjacent pairs of the plurality of conductive pillars, each of the second plurality of dielectric portions comprising extensions that extend at least partially between a conductive pillar of the plurality of conductive pillars and the plurality of first word line portions and at least partially between the conductive pillar and the plurality of second word line portions.

6. The apparatus of claim 5, wherein each of the extensions of the second plurality of dielectric portions is in contact with one or more of the first plurality of memory cells or one or more of a second plurality of memory cells.

7. The apparatus of either of claims 5 or 6, wherein each of the second plurality of dielectric portions comprises the memory material, a dielectric seal material, and an oxide material.

8. The apparatus of claim 7, wherein the memory material forms a perimeter around the second plurality of dielectric portions and surrounds the dielectric seal material.

9. The apparatus of either of claims 7 or 8, wherein the dielectric seal material forms a perimeter around the second plurality of dielectric portions.

10. A method, comprising:
forming a plurality of piers through a stack of layers comprising a first material and a second material based at least in part on forming a first plurality of cavities through the stack of layers and filling the first plurality of cavities with a third material;
forming a second plurality of cavities through the stack of layers;
forming a plurality of first word lines and a plurality of second word lines based at least in part on removing the second material to form an interleaved pair of comb structures comprising the first material and adjacent to a first plurality of voids;
adding an electrode material in each cavity of the second plurality of cavities, the electrode material in contact with a first word line of the plurality of first word lines or a second word line of the plurality of second word lines;
forming a plurality of pillars in the second plurality of cavities based at least in part on depositing a conductive material in the second plurality of cavities;
forming a third plurality of cavities between the plurality of pillars based at least in part on removing at least a subset of piers of the plurality of piers and one or more portions of a sacrificial material in each cavity of the second plurality of cavities and in contact with the electrode material, each cavity of the third plurality of cavities exposing a respective first sidewall and one or more portions of respective second and third sidewalls of a pillar of the plurality of pillars;
adding a memory material at a boundary surface of each cavity of the third plurality of cavities, wherein a respective first portion of the memory material contacts one of the respective second and third sidewalls of a pillar of the plurality of pillars and a respective second portion of the memory material contacts the electrode material;
forming a plurality of memory cells based at least in part on adding the memory material at the boundary surface of each cavity of the third plurality of cavities, each memory cell of the plurality of memory cells coupled, via the electrode material, between a pillar of the plurality of pillars and a word line of the plurality of first word lines or the plurality of second word lines; and
forming a plurality of dielectric seals based at least in part on adding a dielectric material in a remaining portion of each cavity of the third plurality of cavities, the plurality of dielectric seals filling an area between the respective first portion of the memory material and the respective second portion of the memory material.

11. The method of claim 10, wherein the remaining portion of each cavity of the third plurality of cavities comprises an area between the respective first portion of the memory material and the respective second portion of the memory material based at least in part on adding the memory material at the boundary surface.

12. The method of either of claims 10 or 11, further comprising:
forming, after forming the plurality of dielectric seals, a plurality of dielectric portions based at least in part on adding a second dielectric material to fill the remaining portion of each cavity of the third plurality of cavities.

13. The method of any of claims 10 to 12, further comprising:
removing, after forming the plurality of dielectric seals, a portion of the memory material and a portion of the dielectric material, wherein at least a portion of the boundary surface of each cavity of the third plurality of cavities is re-exposed after removing the portion of the memory material and the portion of the dielectric material; and
adding the dielectric material in the remaining portion of each cavity of the third plurality of cavities after removing the portion of the memory material and the portion of the dielectric material, the dielectric material contacting at least the re-exposed portion of the boundary surface.

14. The method of claim 13, wherein removing the portion of the memory material and the portion of the dielectric material comprises reducing a distance of the respective first portion of the memory material and the respective second portion of the memory material, and wherein a respective size of each memory cell the plurality of memory cells is in accordance with the reduced distance of the respective first portion of the memory material and the respective second portion of the memory material.

15. The method of either of claims 13 or 14., wherein after removing the portion of the memory material and the portion of the dielectric material, a first distance of the respective first portion of the memory material and a second distance of the respective second portion of the memory material are a same distance.
